# EUROPEAN PATENT APPLICATION

(11) **EP 4 385 948 A1**
(43) Date of publication of application: **19.06.2024**
(21) Application number: 22878544.0
(22) Date of filing: 05.10.2022
(51) Int. Cl.: C01B 32/194, G01N 1/28, H01J 37/20

(54) **GRAPHENE GRID, METHOD FOR PRODUCING GRAPHENE GRID, AND METHOD FOR ANALYZING STRUCTURE OF STRUCTURAL ANALYSIS TARGET SUBSTANCE**

(30) Priority: 07.10.2021 JP 2021165333
(71) Applicant: OSAKA UNIVERSITY, Suita-shi Osaka 565-0871 (JP)
(72) Inventor: ASAHARA, Haruyasu, Suita-shi, Osaka 565-0871 (JP); MORIGUCHI, Maiko, Suita-shi, Osaka 565-0871 (JP); INOUE, Tsuyoshi, Suita-shi, Osaka 565-0871 (JP)
(74) Representative: J A Kemp LLP
(86) International application number: PCT/JP2022/037220
(87) International publication number: WO 2023/058676

(57) **Abstract**

A graphene grid that can reduce or prevent uneven distribution, uneven orientation, and the like of a structural analysis target substance, and can capture the structural analysis target substance with high efficiency and analyze the structural analysis target substance with high resolution, in structural analysis by cryo-electron microscopy. To achieve the above object, the graphene grid has a graphene surface onto which a functional group containing at least one of a silicon atom or a phosphorus atom is introduced.

## Description

### TECHNICAL FIELD

The present invention relates to a graphene grid, a method for producing a graphene grid, and a method for analyzing a structural analysis target substance.

### BACKGROUND ART

Cryo-electron microscopy is used for a structural analysis of substances such as proteins (Patent Literature 1, etc.).

For the structural analysis of a structural analysis target substance (e.g., a protein) to be analyzed by cryo-electron microscopy, a carbon grid to which a support film made of graphene or amorphous carbon is attached, is used to capture the structural analysis target substance.

### Citation List

### Patent Literature

Patent Literature 1: JP 2005-250721 A

### SUMMARY OF INVENTION

### Technical Problem

However, when a structural analysis target substance such as a protein is captured by a carbon grid, uneven distribution (localization), uneven orientation, and the like of the structural analysis target substance may occur on the carbon grid or a sufficient number of structural analysis target substances may not be captured, which may hinder the structural analysis. Further, it may be difficult to analyze the structural analysis target substance with high resolution.

With the foregoing in mind, it is an object of the present invention, for example, to provide: a graphene grid that can reduce or prevent uneven distribution, uneven orientation, and the like of a structural analysis target substance, and can capture the structural analysis target substance with high efficiency and analyze the structural analysis target substance with high resolution, in a structural analysis by cryo-electron microscopy or the like; a method for producing a graphene grid; and a method for analyzing a structural analysis target substance using the graphene grid.

### Solution to Problem

To achieve the above object, the present invention provides a graphene grid having a graphene surface onto which a functional group containing at least one of a silicon atom or a phosphorus atom is introduced.

The presnt invention also provides a method for producing a graphene grid having a graphene surface onto which a functional group containing at least one of a silicon atom or a phosphorus atom is introduced, including: introducing the functional group containing a silicon atom by a reaction of a substituent in the graphene surface with at least one of a silane coupling agent or a phosphonic acid derivative.

The present invention also provides a method for analyzing a structural analysis target substance using cryo-electron microscopy, including: preparing a grid for structural analysis; and analyzing a structural analysis target substance, wherein, in the preparing a grid for structural analysis, the structural analysis target substance is bonded to the graphene grid of the present invention or a graphene grid produced by the method for producing a graphene grid according to the present invention; or the grid for cryo-electron microscopy of the present invention or a grid for cryo-electron microscopy produced by the method for producing a grid for cryo-electron microscopy according to the present invention is prepared, and in the analyzing a structural analysis target substance, the structural analysis target substance bonded to the graphene grid is analyzed by cryo-electron microscopy.

### Advantageous Effects of Invention

The present invention can provide, for example, a graphene grid that can reduce or prevent uneven distribution, uneven orientation, and the like of a structural analysis target substance, and can capture the structural analysis target substance with high efficiency and analyze the structural analysis target substance with high resolution, in a structural analysis by cryo-electron microscopy or the like, a method for producing a graphene grid, and a method for analyzing a structural analysis target substance using the graphene grid.

### BRIEF DESCRIPTION OF DRAWINGS

[FIG. 1] FIG. 1 is a diagram schematically showing an example of an apparatus for performing the surface treatment using a reaction in a gas phase.
[FIG. 2] FIG. 2 is a diagram schematically showing an example of the surface treatment using a liquid reaction system.
[FIG. 3] FIG. 3 is a graph showing the XPS measurement results of graphene before and after the surface treatment (oxidation reaction) in the Reference Examples.
[FIG. 4] FIG. 4 shows an example of the measurement results by AFM before and after the surface treatment (oxidation) of graphene.
[FIG. 5] FIG. 5 is a graph showing the fluorescence intensity measurement results of graphene to which rhodamine B is bonded in the Reference Examples.
[FIG. 6] FIG. 6 shows a schematic view of an apparatus in which the surface treatment is performed using a reaction in a gas phase in the Reference Examples and shows a diagram showing contact angles of water on graphene surfaces before and after the surface treatment.
[FIG. 7] The upper part of FIG. 7 is a scheme schematically showing a reaction of GroEL bond to the graphene grid produced in the Examples. The lower part of FIG. 7 is a photograph of the graphene grid surface bonded to the GroEL observed at 15,000× magnification by a negative staining method using a 2% uranyl acetate aqueous solution.
[FIG. 8] FIG. 8 shows FT-IR spectrums of the graphene on the copper substrate produced in the Examples.
[FIG. 9] The upper part of FIG. 9 shows photographs of the contact angles of water in the graphene grid surfaces before and after the introduction of the functional group (surface modification after oxidation). The middle part of FIG. 9 is a scheme schematically showing a reaction of a GroEL bond to the graphene grid produced in the Examples. The lower part of FIG. 9 is a photograph of the graphene grid (grid for cryo-electron microscopy) surface bonded to the GroEL observed at 15,000× magnification by a negative staining method using a 2% uranyl acetate aqueous solution.
[FIG. 10] The upper part of FIG. 10 shows photographs of the contact angles of water in the graphene grid surfaces before and after the introduction of the functional group ( surface modification after oxidation) in the Examples. The middle part of FIG. 10 is a scheme schematically showing a reaction of a GroEL bond to the graphene grid produced in the Examples. The lower part of FIG. 10 is a photograph of the graphene grid (grid for cryo-electron microscopy) surface bonded to the GroEL observed at 15,000× magnification by a negative staining method using a 2% uranyl acetate aqueous solution.
[FIG. 11] The upper part of FIG. 11 is a scheme schematically showing a reaction of a β-galactosidase bond to the graphene grid produced in the Examples. The lower part of FIG. 11 is a photograph of the graphene grid (grid for cryo-electron microscopy) surface bonded to the β-galactosidase observed at 15,000× magnification by a negative staining method using a 2% uranyl acetate aqueous solution.
[FIG. 12] The upper part of FIG. 12 is a FT-IR spectrum of the graphene on the copper substrate onto which a functional group is introduced in the Examples. The lower part of FIG. 12 shows photographs of the contact angles of water in the graphene surfaces on the copper substrates before and after the functional group-introduction (surface modification after oxidation) in the Examples.
[FIG. 13] FIG. 13 is a FT-IR spectrum of the graphene on the copper substrate produced in the Examples.
[FIG. 14] FIG. 14 is a FT-IR spectrum of the graphene on the copper substrate produced in the Examples.
[FIG. 15] FIG. 15 is a FT-IR spectrum of the graphene on the copper substrate produced in the Examples.
[FIG. 16] FIG. 16 is a FT-IR spectrum of the graphene on the copper substrate produced in the Examples.
[FIG. 17] FIG. 17 is a FT-IR spectrum of the oxidized graphene on the copper substrate produced in the Examples.
[FIG. 18] The upper part of FIG. 18 is a scheme schematically showing a reaction of GroEL bond to the graphene grid onto which zwitterion is introduced. The lower part of FIG. 18 shows photographs of the graphene grid (grid for cryo-electron microscopy) surfaces bonded to the GroEL observed at 15,000× magnification by a negative staining method using a 2% uranyl acetate aqueous solution.

### DESCRIPTION OF EMBODIMENTS

The present invention will be described below in more detail with reference to illustrative examples. The present invention, however, is not limited by the following description.

The graphene grid of the present invention may have, for example, a graphene surface onto which a substituent is introduced, and the functional group is further introduced by a reaction of the substituent.

In the graphene grid of the present invention, the substituent may be, for example, at least one substituent selected from the group consisting of a hydroxyl group, a carboxy group, an aldehyde group, a substituent containing a ketone group or a carbonyl group, a substituent containing an ether bond, and a substituent containing an ester bond. A structure of the substituent containing a ketone group or a carbonyl group and a structure of the substituent containing an ester bond are not particularly limited and may be, for example, a structure in which a part of a graphene skeleton has changed as shown in the following chemical formula A1. The substituent containing an ether bond may be, for example, an epoxy group or the like. A structure of the epoxy group is not particularly limited and may be, for example, a structure shown in chemical formula E1 described below with reference to Example 1.

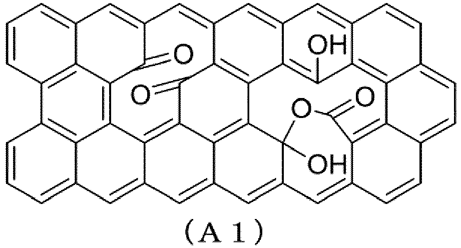

The graphene grid of the present inventionmay have a structure onto which the functional group is introduced, for example, by a reaction of the substituent with at least one of a silane coupling agent or a phosphonic acid derivative.

In the graphene grid of the present invention, for example, the functional group containing at least one of a silicon atom or a phosphorus atom may be a functional group containing at least one selected from the group consisting of a hydroxy group, a carboxy group, an aldehyde group, a carbonyl group, an ether bond, an epoxy group, an ester bond, an amino group, an imino group, a maleimide group, a sulfonyl group, a sulfonyloxy group, a fluoroalkyl group, a cyano group, an isocyanato group (isocyanate group), a vinyl group, a styryl group, a methacrylic group, an acrylic group, a ureido group, a mercapto group, an isothiocyanate group, an azido group, an ethynyl group, an imidoester group, a halide, an activated carboxy group, an NHS ester group, an acid chloride, an acid anhydride, and a fluoro ester. Non-limiting examples of the activated carboxy group include atomic groups such as the NHS ester group, the acid chloride, the acid anhydride, and the fluoro ester.

The graphene grid of the present invention may be, for example, a grid for cryo-electron microscopy being the graphene grid of the present invention to which a structural analysis target substance to be analyzed by cryo-electron microscopy is bonded.

The grid for cryo-electron microscopy of the present invention may be, for example, a grid for cryo-electron microscopy being the graphene grid of the present invention to which a structural analysis target substance to be analyzed by the cryo-electron microscopy is bonded.

The grid for cryo-electron microscopy of the present invention may be, for example, a grid for cryo-electron microscopy being the graphene grid of the present invention to which a structural analysis target substance to be analyzed by the cryo-electron microscopy is not bonded.

The method for producing a graphene grid according to the present invention (hereinafter sometimes merely referred to as "the production method of the present invention") may further include, for example, introducing the substituent by reacting a graphene surface with a halogen oxide radical to modify the graphene surface.

In the production method of the present invention, for example, the halogen oxide radical may be a chlorine dioxide radical.

In the production method of the present invention, for example, the substituent may be at least one substituent selected from the group consisting of a hydroxyl group, a carboxy group, an aldehyde group, a substituent containing a ketone group or a carbonyl group, a substituent containing an ether bond, and a substituent containing an ester bond. The substituent containing a ketone group or a carbonyl group, the substituent containing an acyl group, and the substituent containing an ester bond are not particularly limited and are, for example, as described above.

In the production method of the present invention, for example, the functional group containing at least one of a silicon atom or a phosphorus atom may be a functional group containing at least one selected from the group consisting of a hydroxy group, a carboxy group, an aldehyde group, a carbonyl group, an ether bond, an epoxy group, an ester bond, an amino group, an imino group, a maleimide group, a sulfonyl group, a sulfonyloxy group, a fluoroalkyl group, a cyano group, an isocyanato group (isocyanate group), a vinyl group, a styryl group, a methacrylic group, an acrylic group, a ureido group, a mercapto group, an isothiocyanate group, an azido group, an ethynyl group, an imidoester group, a halide, an activated carboxy group, an NHS ester group, an acid chloride, an acid anhydride, and a fluoro ester. Non-limiting examples of the "activated carboxy group" include atomic groups such as the NHS ester group, the acid chloride, the acid anhydride, and the fluoro ester.

In the production method of the present invention, for example, a substance with the graphene surface oxidized and modified through the substituent-introduction may be a substance with an oxidized graphene surface.

In the production method of the present invention, for example, in the substituent introduction, a reaction system may or may not be irradiated with light.

In the production method of the present invention, for example, the reaction system in the substituent introduction may be a gas reaction system or a liquid reaction system.

The production method of the present invention may be, for example, a method for producing a grid for cryo-electron microscopy including the process of: binding a structural analysis target substance to be analyzed by cryo-electron microscopy to the graphene grid produced by the method of the present invention.

The grid for cryo-electron microscopy produced by the production method of the present invention may be a graphene grid to which a structural analysis target substance to be analyzed by cryo-electron microscopy is bonded, or may be a graphene grid to which a structural analysis target substance to be analyzed by cryo-electron microscopy is not bonded.

In the method for analyzing a structural analysis target substance according to the present invention, for example, the structural analysis target substance may be an organic substance.

In the method for analyzing a structural analysis target substance according to the present invention, for example, the organic substance may be a protein.

The graphene grid of the present invention may be, for example, a grid for instrumental analysis.

The graphene grid of the present invention may be, for example, a grid for electron microscopy.

The graphene grid of the present invention may be, for example, a grid for cryo-electron microscopy.

Further, the use of the graphene grid of the present invention is not limited to a grid for instrumental analysis, a grid for electron microscopy, and a grid for cryo-electron microscopy, and can be used, for example, in applications such as a bioreactor, a sensor (e.g., a biosensor such as an enzyme sensor), a microreactor, and the like, and can also be used in detection reagents when an antibody or various proteins are linked to beads or the like, affinity column chromatography, and the like.

The grid for cryo-electron microscopy of the present invention can be used in a structural analysis method for a structural analysis target substance using cryo-electron microscopy. The specific usage of the grid for cryo-electron microscopy is not particularly limited, and may be, for example, the same as that of a general grid for cryo-electron microscopy. The structural analysis target substance is not particularly limited and may be, for example, at least one selected from the group consisting of a protein, an antibody, a nucleic acid, a virus, a ribosome, a mitochondrion, an ion channel, an enzyme, and an enzyme complex. Examples of the protein that is the structural analysis target substance include, but are not limited to, enzymes, chaperonin proteins, iron storage proteins, antibody-antigen complexes, and virus-derived surface proteins. Examples of the enzyme include, but are not limited to, β-galactosidase and V1-ATPase. The chaperonin protein is not particularly limited, and may be, for example, GroEL. The iron storage protein is not particularly limited, and may be, for example, ferritin. The structural analysis target substance may be, for example, a biological substance (a substance derived from a living body or a substance identical thereto), but is not limited thereto and may be selected freely.

The present invention can achieve, for example, introducing an appropriate functional group on a graphene grid easily and efficiently to immobilize and stabilize a structural analysis target substance to be analyzed by cryo-electron microscopy (e.g., a protein or the like).

The production method of the present invention achieves, for example, forming a stable bond between a silane coupling agent (organic silane) or a phosphonic acid derivative and a substituent in a surface-treated graphene grid surface, thereby improving stability after introducing a functional group, and allowing a wide variety of functional groups to be introduced.

In the production method of the present invention, the substituent introduction that introduces a substituent to the graphene surface also modifies the graphene surface, as described above. Hereinafter, in the present specification, the substituent introduction is sometimes referred to as "surface treatment", "modification treatment", or "modification method". When oxidizing the graphene through the surface treatment, the surface treatment can refer to the graphene oxidation method.

In the present invention, a "substituent" and a "functional group" are not particularly limited and may be, for example, as described above. The "substituent" and the "functional group" may each be, for example, a hydrocarbon group or a derivative group thereof. The hydrocarbon group or the derivative group thereof is not particularly limited and is, for example, a monovalent group of the following hydrocarbons or the derivative thereof. The hydrocarbon may be, for example, nonaromatic or aromatic, and may be saturated or unsaturated. Specifically, the hydrocarbon may be, for example, a linear or branched, and saturated or unsaturated hydrocarbon (e.g., a linear or branched alkane, a linear or branched alkene, a linear or branched alkyne, and the like). The hydrocarbon may also be, for example, a saturated or unsaturated hydrocarbon having a nonaromatic cyclic structure (e.g., cycloalkane, cycloalkene and the like). The hydrocarbon may be an aromatic hydrocarbon. In addition, The hydrocarbon, for example, may or may not have one or two or more, aromatic or nonaromatic rings, in the structure thereof. The hydrocarbon may or may not have one or two or more, linear or branched and saturated or unsaturated hydrocarbon groups, in the structure thereof. The unsaturated hydrocarbon may be, for example, a ketone, an ester, an amido, or the like having a carbonyl group (-C(=O)-). The carbon number of the hydrocarbon is not particularly limited and may be, for example, 1 to 40, 1 to 32, 1 to 24, 1 to 18, 1 to 12, 1 to 6, or 1 to 2. When the hydrocarbon is an unsaturated hydrocarbon, the carbon number may be, for example, 2 to 40, 2 to 32, 2 to 24, 2 to 18, 2 to 12, or 2 to 6. Specific examples of the hydrocarbon include methane, ethane, propane, n-butane, 2-methylpropane, n-pentane, n-hexane, ethylene, propylene, 1,3-butadiene, acetylene, cyclopentane, cyclohexane, cycloheptane, cyclooctane, methylcyclohexane, cyclohexene, benzene, toluene, o-xylene, m-xylene, p-xylene, mesitylene, durene, biphenyl, naphthalene, 1-methylnaphtalene, 2-methynaphtalene, anthracene, phenanthrene, pyrene, and styrene.

A "derivative" of the hydrocarbon is, for example, an organic compound containing a hetero element (element other than carbon or hydrogen). The hetero element is not particularly limited, and examples thereof include oxygen(O), nitrogen(N), sulfur(S) and a halogen. Examples of the halogen include fluorine(F), chlorine(Cl), bromine(Br), and iodine(I). The derivative may be, for example, an organic compound in which a hydrocarbon group and a freely selected substituent or atom group are bonded to each other. The derivative may be, for example, a compound in which two or more hydrocarbon groups are bonded to each other with a freely selected atom group. The hydrocarbon group may or may not be substituted with one or two or more freely selected substituents. The hydrocarbon group is not particularly limited and may be, for example, monovalent or bivalent or more groups derived from the hydrocarbon group. In the hydrocarbon group, for example, one or two or more of the carbon atoms may be substituted with a hetero atom. Specifically, for example, one carbon atom (and a hydrogen atom bonded thereto) of a phenyl group may be substituted with a nitrogen atom to form a pyridyl group. The substituent and the atom group are not particularly limited and examples thereof include a hydroxy group, a halogen group (a fluoro group, a chloro group, a buromo group, an iodo group, or the like), an alkoxy group, an aryloxy group (e.g., a phenoxy group or the like), a carboxy group, an alkoxycarbonyl group, an aryloxycarbonyl group (e.g., a phenoxycarbonyl group or the like), a mercapto group, an alkylthio group, an arylthio group (e.g., a phenylthio group or the like), an amino group having or not having a substituent (e.g., an amino group, an alkylamino group, a dialkylamino group and the like), an ether bond (-O-), an ester bond (-CO-O-), and a thioether bond (-S-).

In the present invention, a chain-like substituent (e.g., an alkyl group, a hydrocarbon group such as an unsaturated aliphatic hydrocarbon group) may be linear or branched unless otherwise stated. The carbon number of the chain-like substituent is not particularly limited and may be, for example, 1 to 40, 1 to 32, 1 to 24, 1 to 18, 1 to 12, 1 to 6, or 1 to 2 (2 or more when the chain-like substituent is an unsaturated hydrocarbon group). In the prevent invention, the number of ring members (number of atoms forming a ring) of a cyclic group (e.g., an aryl group, a heteroaryl group, and the like) is not particularly limited and may be, for example, 5 to 32, 5 to 24, 6 to 18, 6 to 12, or 6 to 10. When the substituent or the like have an isomer, the isomer may be any isomer unless otherwise stated. For example, a mere "naphthyl group" may be a 1-naphthyl group or a 2-naphthyl group.

In the present invention, the salt discussed below is not particularly limited, and may be, for example, an acid addition salt or a base addition salt. An acid that forms the acid addition salt may be, for example, either an inorganic acid or an organic acid, and a base that forms the base addition salt may be, for example, either an inorganic base or an organic base. The inorganic acid is not particularly limited, and examples thereof include sulfuric acid, phosphoric acid, hydrofluoric acid, hydrochloric acid, hydrobromic acid, hydroiodic acid, hypofluorous acid, hypochlorous acid, hypobromous acid, hypoiodous acid, fluorous acid, chlorous acid, bromous acid, iodous acid, fluorine acid, chloric acid, bromic acid, iodic acid, perfluoric acid, perchloric acid, perbromic acid, and periodic acid. The organic acid also is not particularly limited, and examples thereof include p-toluenesulfonic acid, methanesulfonic acid, oxalic acid, p-bromobenzenesulfonic acid, carbonic acid, succinic acid, citric acid, benzoic acid, and acetic acid. The inorganic base is not particularly limited, and examples thereof include ammonium hydroxides, alkali metal hydroxides, alkaline-earth metal hydroxides, carbonates, and hydrogencarbonates. More specifically, the inorganic base may be, for example, sodium hydroxide, potassium hydroxide, potassium carbonate, sodium carbonate, sodium hydrogencarbonate, potassium hydrogencarbonate, calcium hydroxide, or calcium carbonate. The organic base is not particularly limited either, and examples thereof include ethanolamine, triethylamine, and tris(hydroxymethyl)aminomethane.

An embodiment of the present invention will be described below in more detail with reference to illustrative examples. The present invention, however, is by no means limited thereby.

### [1. Surface treatment (Method for Producing Substance with Modified Graphene Surface)]

As described above, the method for producing a graphene grid according to the present invention (the production method of the present invention) includes functional group introduction that introduces a functional group containing a silicon atom by reacting a substituent on a graphene surface having the substituent with at least one of a silane coupling agent or a phosphonic acid derivative. Before the functional group introduction, the production method of the present invention may include, for example, substituent introduction (surface treatment) that introduces the substituent by reacting a graphene surface with a halogen oxide radical to modify the graphene surface as described above. The surface treatment can be referred to as a method for producing a substance with a modified graphene surface. Hereinafter, the surface treatment will be described specifically with reference to illustrated examples.

### (1) Graphene

The graphene is a kind of carbon allotrope. Examples of the carbon allotrope other than graphene include diamond-like carbon (hereinafter, sometimes referred to as "DLC"), carbon nanotube, fullerene, nanodiamond, graphite, diamond, and carbon fiber. As described above, the production method of the present invention is characterized in that it includes the processes of: treating a surface by reacting the graphene surface with a halogen oxide radical; and introducing a functional group onto a modified graphene surface. As described above, the graphene grid of the present invention is a graphene grid having a graphene surface onto which a functional group is introduced.

Since graphene is extremely thinner as compared with that of other carbon allotropes, for example, it has an advantage that it is more likely to achieve high resolution when used for instrumental analysis such as a grid for cryo-electron microscopy. Specifically, since graphene theoretically has a thickness of only one atom, for example, the signal/noise ratio tends to be high when the graphene is used in a grid for cryo-electron microscopy. Therefore, as described above, the present invention can analyze the structural analysis target substance with high resolution.

In the present invention, the graphene may or may not include elements other than carbon. Examples of the other elements include hydrogen, oxygen, nitrogen, sulfur, boron, silicon, phosphorus, and various metal elements. As to the graphene, for example, the skeleton may be formed only by a bond between carbon atoms, and the other atoms may be bonded to its surface. For example, the graphene may have groups such as a hydroxy group, a methyl group, a carboxy group, an aldehyde group, a carbonyl group, an ether bond, an ester bond, or the like on its face. When the graphene includes the other elements, the content is not particularly limited, and may be, for example, 40% or less, 20% or less, or 5% or less of the total number of atoms, or, for example, may be 0.01% or more, 0.1% or more, or 1% or more of the total number of atoms.

According to the surface treatment of the present invention, for example, as will be described below, a functional group such as a hydroxy group, a carboxy group, or the like can be introduced by oxidizing the graphene surface. Although this mechanism is unknown, it is presumed that, for example, a methyl group or the like of the graphene surface is oxidized and converted into a hydroxymethyl group, a carboxy group, or the like. However, this description is speculative and the present invention is not limited by this description.

### (2) Halogen Oxide Radical

In the present invention, the halogen oxide radical is contained in a reaction system of the surface treatment. For example, the halogen oxide radical may be contained in the reaction system by generating in the reaction system or by adding to the reaction system the halogen oxide radical that has been generated separately. How the halogen oxide radical is generated is not particularly limited. A specific example of the generation of the halogen oxide radical will be described below.

For example, as the halogen oxide radical, any one of them may be used, or two or more of them may be used in combination. The halogen oxide radical may be appropriately selected, for example, depending on the type of the graphene to be modified, the reaction conditions, and the like.

Examples of the halogen oxide radical include halogen oxide radicals such as F₂O· (oxygen difluoride radical), F₂O₂· (dioxygen difluoride radical), ClO₂· (chlorine dioxide radical), BrO₂· (bromine dioxide radical), I₂O₅· (iodine (V) oxide), and the like.

### (3) Reaction System

The reaction system in the surface treatment contains the graphene and the halogen oxide radical. The reaction system may be, as described above, for example, either a gas reaction system or a liquid reaction system. In the surface treatment, for example, the reaction system may or may not be irradiated with light. That is, the graphene and the halogen oxide radical can be reacted with each other without irradiating the graphene with light. No irradiation of the graphene with light allows, for example, safety to be improved, and costs to be reduced. For example, a halogen oxide radical may be generated by light irradiation in a radical generation reaction system that is different from the reaction system of the surface treatment so as not to irradiate the reaction system of the surface treatment with light. Note that how to generate the halogen oxide radical itself is not particularly limited as described above, and the halogen oxide radical may be generated without light irradiation.

### (3A) Gas Reaction System

When the reaction system is a gas reaction system, for example, the graphene is placed in the gas reaction system containing the halogen oxide radical and irradiated with light. In the present invention, however, the surface treatment is not limited thereto. For example, the surface treatment may be performed without light irradiation as long as the graphene surface can be reacted with the halogen oxide radical. The gas reaction system is not particularly limited as long as it contains the radical, for example, and non-limiting examples of the type of the gas phase in the gas reaction system include air, nitrogen, noble gas, and oxygen.

In the present invention, for example, the halogen oxide radical may be introduced into or generated in the gas reaction system prior to or in parallel with the surface treatment. In the former case, for example, a gas containing the halogen oxide radical may be introduced into the gas phase. In the latter case, for example, as will be described below, the halogen oxide radical generated in the radical generation reaction system in a liquid phase may be introduced by transferring the halogen oxide radical to a gas phase.

As a specific example, when the halogen oxide radical is the chlorine dioxide radical, for example, the chlorine dioxide radical may be present in the gas phase by introducing a chlorine dioxide gas into the gas phase. The chlorine dioxide radical may be generated, for example, in the gas phase by an electrochemical method.

### (3B) Liquid Reaction System

When the reaction system is the liquid reaction system, the liquid reaction system contains, for example, an organic phase. The liquid reaction system may be a one-phase reaction system containing only the organic phase, or a two-phase reaction system containing, for example, the organic phase and an aqueous phase. For the one-phase reaction system containing only the organic phase, for example, as will be described below, an aqueous phase containing a source of the halogen oxide radical may be prepared separately to generate the halogen oxide radical in the aqueous phase, and the organic phase may then be mixed with the aqueous phase to dissolve (extract), in the organic phase, the halogen oxide radical generated in the aqueous phase.

### (3B-1) Organic Phase

The organic phase contains the graphene placed therein, as described above, and is, for example, a phase of an organic solvent containing the halogen oxide radical and the graphene placed therein.

The organic solvent is not particularly limited. For example, only one type of the organic solvent may be used, or two or more types may be used in combination. In the present invention, examples of the organic solvent include a halogenated solvent and a fluorous solvent, as described above. When the liquid reaction system is the two-phase reaction system, the organic solvent is preferably, for example, a solvent that can form the two-phase system, i.e., a solvent that separates from an aqueous solvent constituting the aqueous phase described below, or a solvent that is poorly soluble or insoluble in the aqueous solvent.

The "halogenated solvent" refers, for example, to a solvent in which all or most of the hydrogen atoms of a hydrocarbon have been substituted with halogen. The halogenated solvent may be, for example, a solvent in which 50% or more, 60% or more, 70% or more, 80% or more, or 90% or more of hydrogen atoms of the hydrocarbon are substituted with halogen. The halogenated solvent is not particularly limited, and examples thereof include methylene chloride, chloroform, carbon tetrachloride, carbon tetrabromide, and a fluorous solvent described below.

The "fluorous solvent" is one of the aforementioned halogenated solvents, and is, for example, a solvent in which all or most of the hydrogen atoms of a hydrocarbon have been substituted with fluorine atoms. The fluorous solvent may be, for example, a solvent in which 50% or more, 60% or more, 70% or more, 80% or more, or 90% or more of hydrogen atoms of the hydrocarbon are substituted with fluorine atoms. In the present invention, the use of the fluorous solvent is advantageous, for example, in reducing or preventing side reactions due to the low reactivity of the fluorous solvent itself. Examples of the side reactions include an oxidation reaction of the solvent, a hydrogen abstraction reaction of the solvent with the radical, halogenation (e.g., chlorination), and a reaction of a radical derived from a raw material compound and the solvent (e.g., a reaction of an ethyl radical and the solvent, when the hydrocarbon group in the side chain or at the terminal of the graphene is an ethyl group). Since the fluorous solvent is not easily miscible with water, for example, the fluorous solvent is suitable for forming the two-phase reaction system.

Examples of the fluorous solvent include solvents represented by the following chemical formulae (F1) to (F6). Among them, the fluorous solvent is, for example, preferably CF₃(CF₂)₄CF₃ having the following chemical formula (F 1) where n = 4.

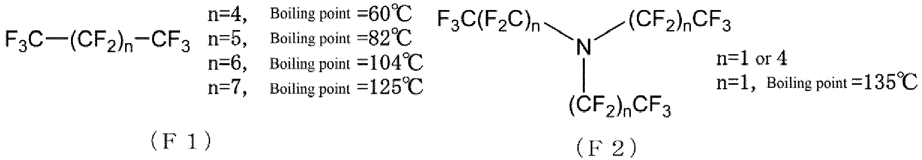

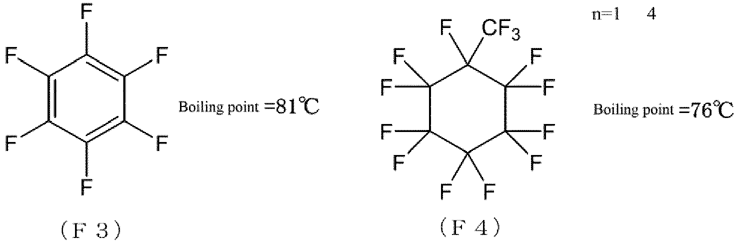

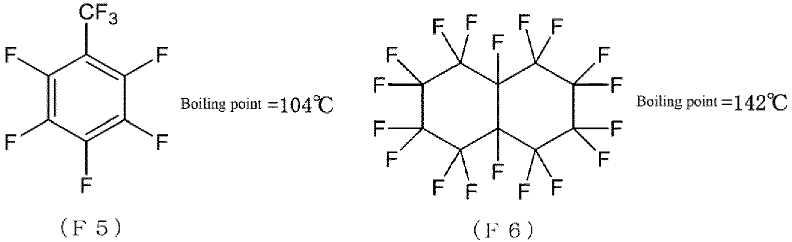

The boiling point of the organic solvent is not particularly limited. The organic solvent may be appropriately selected, for example, depending on the temperature conditions in the surface treatment. For the high reaction temperature set in the surface treatment, a high boiling point solvent may be selected as the organic solvent. Note that, for example, as will be described below, for example, heating is not essential in the present invention, and the present invention can be implemented, for example, at ordinary temperature and normal pressure. In such a case, the organic solvent need not be, for example, a solvent having a high boiling point, and a solvent having a low boiling point can be used from the viewpoint of ease of handling.

The organic phase may contain, for example, only the graphene, the halogen oxide radical, and the organic solvent, but may further contain other components. The other component is not particularly limited, and examples thereof include Brønsted acid, Lewis acid, and oxygen (O₂). In the organic phase, for example, the other components may be dissolved in the organic solvent or may be undissolved. In the latter case, the other component may be, for example, dispersed or precipitated in the organic solvent.

The organic phase contains the halogen oxide radical as described above. The organic phase may contain the halogen oxide radical, for example, by generating the halogen oxide radical in a phase other than the organic phase and extracting the halogen oxide radical. Specifically, when the reaction system is a one-phase reaction system containing only an organic phase, for example, the halogen oxide radical is generated separately in a phase other than the organic phase being the reaction system, the generated halogen oxide radical is extracted with the organic phase, and the organic phase containing the extracted halogen oxide radical as the reaction system can be used for the surface treatment. The generation of the halogen oxide radical may be performed, for example, in the aqueous phase provided separately, as will be described below. On the other hand, when the liquid reaction system is a two-phase reaction system containing the organic phase and the aqueous phase, for example, the halogen oxide radical is generated in the aqueous phase, the generated halogen oxide radical is extracted from the aqueous phase in the organic phase, and the aqueous phase and the organic phase containing the halogen oxide radical can be used for the surface treatment as the two-phase reaction system.

The graphene is placed in the organic phase. When the graphene is the molded body, the molded body is, for example, preferably fixed in the organic phase such that a portion of the molded body to be surface-treated is immersed in the organic phase and is not exposed from the organic phase, for example, from the point of view of the efficiency of the reaction process described later.

### (3B-2) Aqueous Phase

The aqueous phase is, for example, a phase of an aqueous solvent. The aqueous solvent is, for example, a solvent that is separated from the solvent used in the organic phase. Examples of the aqueous solvent include water such as H₂O and D₂O.

The aqueous phase may contain any component, for example, such as a Lewis acid, a Brønsted acid, a radical source, or the like, as described below. In the aqueous phase, these optional components may be, for example, dissolved or undissolved in the aqueous solvent. In the latter case, the optional component may be, for example, dispersed or precipitated in the aqueous solvent.

### (4) Surface Treatment

The surface treatment is for reacting the graphene surface with the halogen oxide radical, as described above. In the surface treatment, for example, the reaction system of the reaction may or may not be irradiated with light. While a method in which the reaction system is irradiated with light will be mainly described below, the present invention is not limited thereto. The surface treatment is not particularly limited, as described above, as long as the graphene surface can be reacted with the halogen oxide radical, and the surface treatment may be performed without light irradiation. In such cases, for example, the surface treatment can be performed without light irradiating in the following description. As described above, by not requiring irradiation of the graphene with light, for example, safety can be improved, and costs can be reduced.

The reaction system contains the graphene placed therein, and the graphene may be modified. Specifically, the present invention allows the graphene to be modified easily in the presence of the halogen oxide radical. The present invention allows, for example, the degree of modification of the graphene (e.g., the degree of modification such as oxidation) to be easily adjusted through adjustment of the amount of the halogen oxide radical, the light irradiation time, and the like. Thus, for example, decomposition of the graphene due to excessive oxidation or the like can be prevented, and, for example, the characteristic inherent in the graphene can be prevented from being impaired.

In the surface treatment, when a methyl group is present on the graphene surface, a methyl group (-CH₃) is oxidized into, for example, at least one of a hydroxymethyl group (-CH₂OH), a formyl group (-CHO), or a carboxyl group (-COOH). This presumes the following mechanism. For example, the light irradiation generates a radical of the halogen (e.g., a chlorine radical (Cl·)) and a molecule of the oxygen from the halogen oxide radical (e.g., a chlorine dioxide radical). Then, in the methyl group (-CH₃) on the graphene surface, the radical of the halogen (e.g., a chlorine radical (Cl·)) functions as a hydrogen extracting agent and becomes a carbo radical (-CH₂·), and then the molecule of the oxygen (e.g., O₂) functions as an oxidizing agent and becomes a hydroxymethyl group (-CH₂OH). The hydroxymethyl group (-CH₂OH) is further oxidized to a formyl group (-CHO) or a carboxy group (-COOH).

When an ethyl group is present on the graphene surface in the surface treatment, the ethyl group (-CH₂CH₃) is oxidized into, for example, a hydroxyethyl group (-CH₂CH₂OH), an acetaldehyde group (-CH₂CHO), or a carboxymethyl group (-CH₂COOH).

Further, for example, when the graphene surface has a methylene group (-CH₂-), for example, the methylene group is oxidized into a hydroxymethylene group (-CHOH-), a carbonyl group (-CO-), or the like.

In the surface treatment, the conditions of light irradiation are not particularly limited. The wavelength of the irradiation light is not particularly limited, and the lower limit is, for example, 200 nm or more and the upper limit is, for example, 800 nm or less. The light irradiation time is not particularly limited, and the lower limit is, for example, 1 second or more, the upper limit is, for example, 1000 hours. The reaction temperature is not particularly limited, and the lower limit is, for example, -20°C or more, the upper limit is, for example, 100°C or less or 40°C or less, and the reaction temperature is, for example, in a range from 0°C to 100°C, or from 0°C to 40°C. The atmospheric pressure at the time of the reaction is not particularly limited, and the lower limit is, for example, 0.1 MPa or more, the upper limit is, for example, 100 MPa or less, 10 MPa or less, or 0.5 MPa or less, and the atmospheric pressure is, for example, in a range from 0.1 to 100 MPa, 0.1 to 10 MPa, or 0.1 to 0.5 MPa. The reaction conditions during the surface treatment are, for example, a temperature from 0°C to 100°C or from 0°C to 40°C, and a pressure from 0.1 to 0.5 MPa. As described above, for example, the surface treatment itself can be performed without light irradiation. The present invention, for example, allows the surface treatment or all processes including the surface treatment to be performed at normal temperature (room temperature) and normal pressure (atmospheric pressure) without heating, pressurizing, or decompressing. The term "room temperature" is not particularly limited, and is, for example, 5°C to 35°C. Therefore, even if the graphene includes, for example, graphene having low heat resistance, it can be applied to the present invention. Further, the present invention, for example, allows the surface treatment or all processes including the surface treatment to be performed in atmosphere without substitution with inactive gas.

The light source of the light irradiation is not particularly limited, and, for example, visible light included in natural light such as sunlight can be used. The natural light, for example, allows excitation to be performed in a simplified manner. Further, as the light source, for example, as a substitute for or in addition to the natural light, light sources such as a xenon lamp, a halogen lamp, a fluorescent lamp, a mercury lamp, and an LED lamp can be used. In the light irradiation, for example, a filter for cutting wavelengths other than the necessary wavelengths further can be used as appropriate.

In the present invention, by irradiating only a freely-selected area of the graphene with light, only that area can be subjected to modification treatment. Such a method of controlling selective light irradiation is not particularly limited, and for example, only a freely-selected area may be irradiated with light, or only an area not to be irradiated with light may be masked and the whole area of the graphene may be irradiated with light.

When the reaction system is the liquid reaction system, for example, at least the organic phase may be irradiated with light in the surface treatment. In the case of a one-phase reaction system consisting only of the organic phase, for example, the surface treatment can be performed by irradiating the one-phase reaction system with light. In the case of a two-phase reaction system containing the organic phase and the aqueous phase, for example, only the organic phase may be irradiated with light, or the two-phase reaction system may be irradiated with light. In the case of the liquid reaction system, for example, the liquid reaction system may be irradiated with light while bringing the liquid reaction system into contact with air, and in the case of the two-phase reaction system, the liquid reaction system may be irradiated with light in a state where oxygen is dissolved in the aqueous phase.

The surface treatment of the present invention can modify the graphene by generating a radical of the halogen (e.g., a chlorine atom radical Cl·) and an oxygen molecule O₂ through, for example, very simple light irradiation in the presence of the halogen oxide radical to bring the graphene to react (e.g., oxidize). Then, for example, the present invention can change and modify the graphene efficiently in a simplified manner even under extremely mild conditions such as normal temperature and normal pressure.

According to the present invention, for example, a substance with a modified graphene surface is obtained without using a toxic heavy metal catalyst or the like. Therefore, as described above, for example, the graphene can be modified efficiently with the low load on the environment in addition to the reaction being performed under the very mild conditions.

As a method of oxidizing the graphene surface, for example, there is a method of using a strong oxidizing agent such as potassium permanganate (KMnO₄), a method using plasma treatment in a gas phase, and a method using UV irradiation in an ozone-atmosphere. However, such methods do not stay with the oxidation of the graphene surface, but may cleave the carbon-carbon bond of the skeleton and may decompose the graphene. In contrast, according to the surface treatment of the present invention, since the reaction can be performed under mild reaction conditions as described above, it is possible to suppress or prevent the cleavage of the carbon-carbon bond of the graphene skeleton. Further, according to the surface treatment of the present invention, it is easy to control the reaction conditions. Specifically, for example, the reaction in the surface treatment can be optionally stopped by stopping the light irradiation, stopping the supply of the halogen oxide radical, and the like. Thus, for example, the cleavage of the carbon-carbon bond of graphene skeleton can be further suppressed, and, for example, the progress of the reaction of the graphene surface can be easily controlled. Therefore, according to the present invention, for example, it is possible to efficiently modify the graphene surface without decomposing graphene. The fact that the deterioration (decomposition, etc.) of graphene after the surface treatment is low can be verified by, for example, observing the graphene surface after the surface treatment by AFM (atomic force microscopy). Further, for example, in a treatment that requires several tens of minutes, such as oxidation by liquid phase treatment using potassium permanganate, ultraviolet (UV) irradiation in an ozone atmosphere, or the like, by using the surface treatment of the present invention, it becomes possible to modify the graphene surface (oxidation reaction), for example by gas phase treatment (dry process), simply and in a short time (within a few minutes), while maintaining the graphene structure. Thus, for example, a functional group can be effectively introduced in the functional group introduction. This description, however, is merely an example, and does not limit the present invention. For example, the reaction system in the surface treatment of the present invention is not limited to the gas reaction system (gas phase treatment) as described above, and may be a liquid reaction system.

### (5) Halogen Oxide Radical-Generating

The present invention, for example, may further include generating a halogen oxide radical. The halogen oxide radical generation may be, for example, performed prior to or in parallel with the surface treatment. How the halogen oxide radical is generated is not particularly limited.

In the halogen oxide radical generation, for example, the halogen oxide radical may be generated using a radical generation reaction system. The reaction system in the surface treatment may be, for example, either the gas reaction system (gas phase) or the liquid reaction system (liquid phase). The radical generation reaction system after the generation of the halogen oxide radical may be, for example, used as it is as the liquid reaction system in the surface treatment.

When the reaction system in the surface treatment is the gas reaction system, for example, the radical generation reaction system may be prepared separately from the reaction system in the surface treatment. The radical generation reaction system may be, for example, an aqueous phase containing a source of the halogen oxide radical. The aqueous phase includes, for example, a source of the halogen oxide radical, and in the generating of the halogen oxide radical, the halogen oxide radical is generated from the source. The aqueous phase is, for example, a phase of an aqueous solvent, and the aqueous solvent is the same as described above. When the halogen oxide radical generated in the aqueous phase is hydrophobic, for example, the halogen oxide radical may be transferred into the organic phase using a two-phase reaction system containing the organic phase and the aqueous phase. As described above, in the case where the surface treatment is performed in the gas reaction system, the halogen oxide radical generation reaction system may be for example, either only an aqueous phase or a two-phase reaction system of an aqueous phase and an organic phase. When the halogen oxide radical is hydrophobic, for example, since the radical generated in the aqueous phase can move directly to the gas phase, the radical generation reaction system may have only the aqueous phase.

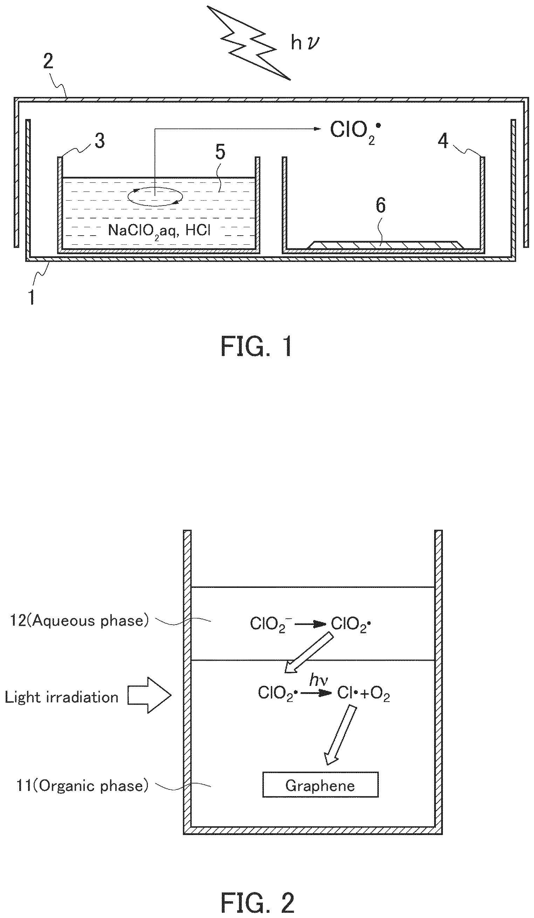

The reaction system in the surface treatment and the radical generation reaction system may be, for example, the reaction system shown in FIG. 1. Specifically, first, a radical generation reaction system 5 is placed in a petri dish 3 as shown in FIG. 1. The radical generation reaction system 5 may be, for example, an aqueous phase containing a source of the halogen oxide radical. The source of the halogen oxide radical is not particularly limited, and is, for example, as described below. Meanwhile, graphene 6 is placed in another petri dish 4. These petri dishes 3 and 4 are housed in yet another large petri dish 1, and a lid 2 is placed to prevent gas inside the petri dish 1 from leaking. Thereafter, the radical generation reaction system 5 in the petri dish 3 is irradiated with light. By this light irradiation, a gas of halogen oxide radical is generated in the petri dish 3, and the gas of the halogen oxide radical flows into the petri dish 4 and reacts with graphene 6. In this manner, the surface treatment can be performed. FIG. 1 illustrates an example in which the source of the halogen oxide radical in the radical generation reaction system 5 is a sodium chlorite aqueous solution (NaClO₂aq) and hydrochloric acid (HCl), and the halogen oxide radical generated by these reactions is a chlorine dioxide radical (ClO₂). However, as described above, in the present invention, the source of the halogen oxide radical and the halogen oxide radical are not limited thereto.

When the reaction system in the surface treatment is the liquid reaction system which contains an aqueous phase, for example, the aqueous phase may be the radical generation reaction system. When the reaction system in the surface treatment is the gas reaction system, the aqueous phase may be, for example, the same as the radical generation reaction system. When the halogen oxide radical generated in the aqueous phase is hydrophobic, for example, the halogen oxide radical may be transferred into the organic phase using a two-phase reaction system containing the organic phase and the aqueous phase.

The source of the halogen oxide radical (radical generation source) is not particularly limited, and may be, for example, selected, as appropriate, according to the type of the halogen oxide radical. For example, one type or two or more types of the source of the halogen oxide radical may be used in combination.

The source of the halogen oxide radical is, for example, a compound containing oxygen and halogen, and can be halous acid (HXOz) or a salt thereof as a specific example. The salt of the halous acid is not particularly limited, and may be, for example, a metal salt, and examples of the metal salt include alkaline metal salts, alkaline earth metal salts, and rare earth salts. The source of the halogen oxide radical may be, for example, a compound containing oxygen, halogen, and a Group 1 element (e.g., at least one selected from the group consisting of H, Li, Na, K, Rb, and Cs), and can be, for example, the halous acid or an alkaline metal salt thereof. When the halogen oxide radical is the chlorine dioxide radical, the source is not particularly limited, and may be, for example, chlorous acid (HClO₂) or salts thereof, and specific examples thereof include sodium chlorite (NaClO₂), lithium chlorite (LiClO₂), potassium chlorite (KClO₂), magnesium chlorite (Mg(ClO₂)₂), and calcium chlorite (Ca(ClO₂)₂). Among them, from the viewpoint of costs, ease of handling, and the like, sodium chlorite (NaClO₂) is preferred. For example, a similar salt or the like can be employed for the source of other halogen oxide radicals. Examples of other source include bromates such as sodium bromate and the like, and iodates such as sodium iodate and the like.

The concentration of the source in the aqueous phase is not particularly limited. When the source is the compound, in terms of the halogen oxide ion concentration, for example, the lower limit of the concentration thereof is 0.0001 mol/L or more and the upper limit thereof is 1 mol/L or less, and, in terms of the molar amount of the halogen oxide ion, for example, the lower limit of the concentration thereof is 1/100000 times or more of the molar amount of the raw material and the upper limit of the concentration thereof is 1000 times or less of the molar amount of the raw material. When the source is halous acid or a halous acid salt (e.g., chlorous acid or chlorite), in terms of a halous acid ion (e.g., chlorite ion (ClO₂-)) concentration, for example, the lower limit of the concentration thereof is 0.0001 mol/L or more and the upper limit of the concentration thereof is 1 mol/L or less, and in terms of the number of moles of the halous acid ion (e.g., chlorite ion (ClO₂-)), for example, the lower limit of the concentration thereof is 1/100000 times or more of the number of moles of the raw material and the upper limit of the concentration thereof is 1000 times or less of the number of moles of the raw material. The above-described concentrations can be, for example, applied also to other sources.

The aqueous phase may further contain, for example, at least one of Lewis acid or Brønsted acid, which may act on the halogen oxide ion to generate the halogen oxide radical. At least one of the Lewis acid or Brønsted acid is, for example, at least one of Lewis acid containing the Group 1 element or Brønsted acid containing the Group 1 element. The halogen oxide ion is, for example, a chlorite ion (ClO₂-). The aqueous phase contains, for example, either one of or both of the Lewis acid or Brønsted acid, or one substance serving as both of the Lewis acid and Brønsted acid. Only one type each of the Lewis acid and Brønsted acid may be used, or two or more types each of the Lewis acid and Brønsted acid may be used in combination. In the present invention, the "Lewis acid" refers to, for example, a substance serving as Lewis acid for the source of the halogen oxide radical.

The concentration of at least one of the Lewis acid or Brønsted acid in the aqueous phase is not particularly limited and can be set, for example, as appropriate, according to the type of the graphene to be modified. The lower limit of the concentration is, for example, 0.0001 mol/L or more and the upper limit of the concentration is, for example, 1 mol/L or less.

The Brønsted acid is not particularly limited, and may be, for example, an inorganic acid or an organic acid. Specific examples of the Brønsted acid include trifluoromethanesulfonic acid, trifluoroacetic acid, acetic acid, hydrofluoric acid, hydrochloric acid, hydrobromic acid, hydroiodic acid, sulfuric acid, sulfurous acid, nitric acid, nitrous acid, phosphoric acid, and phosphorous acid. The acid dissociation constant pKₐ of the Brønsted acid is, for example, 10 or less. The lower limit of the pKₐ is not particularly limited, and is, for example, -10 or more.

It is preferred that the aqueous phase contains, for example, the halogen oxide ion and the Brønsted acid, and is, for example, an aqueous phase obtained by dissolving the compound and the Brønsted acid (e.g., hydrochloric acid) in an aqueous solvent. As a specific example, when the halogen oxide radical is a chlorine dioxide radical, it is preferred that the aqueous phase contains, for example, chlorite ion (ClO₂-) and Brønsted acid, and is, for example, an aqueous phase obtained by dissolving the sodium chlorite (NaClO₂) and the Brønsted acid (e.g., hydrochloric acid) in an aqueous solvent.

In the aqueous phase, the Lewis acid, the Brønsted acid, the radical generation source, and the like may be, for example, dissolved or undissolved in the aqueous solvent. In the latter case, these may be, for example, dispersed or precipitated in the aqueous solvent.

The halogen oxide radical-generating is not particularly limited, and may be performed by bringing the source of the halogen oxide radical to be contained in the aqueous solvent to naturally generate the halogen oxide radical (e.g., a chlorine dioxide radical) from the halogen oxide ion (e.g., a chlorite ion). For example, it is preferable that the source be dissolved in the aqueous solvent in the aqueous phase, and it is preferable that the aqueous phase be left to stand. In the halogen oxide radical-generating, for example, the coexistence of at least one of the Lewis acid or the Brønsted acid in the aqueous phase allows the generation of the halogen oxide radical to be further promoted. In the halogen oxide radical-generating, for example, the halogen oxide radical may be generated by irradiating the aqueous phase with light, and may also be generated by merely leaving the aqueous phase to stand without the light irradiation.

The mechanism of generation of the halogen oxide radical from the halogen oxide ion in the aqueous phase is presumed to be the same as that in FIG. 2 (a liquid phase reaction system, a two-phase system of an organic phase and an aqueous phase), for example, which will be described below. It is to be noted, however, that this description is merely an illustrative example, and by no means limits the present invention thereto.

When the reaction system is the liquid reaction system, and a two-phase reaction system of the organic phase and the aqueous phase, as described above, the liquid reaction system after generation of the halogen oxide radical may be applied as it is to the surface treatment. Since the halogen oxide radical generated from the source in the aqueous phase in the reaction system is hardly dissolved in water, the halogen oxide radical is dissolved in the organic phase in the reaction system. For example, in the liquid reaction system generating the halogen oxide radical, it is possible to perform the surface treatment that modifies a surface of graphene further by irradiating light. In such a case, for example, the halogen oxide radical generation and the surface treatment can be performed continuously by irradiating the liquid reaction system with light. In the present invention, the halogen oxide radical generation and the surface treatment in the two-phase reaction system achieve, for example, higher reaction efficiency.

On the other hand, when the reaction system in the surface treatment is the liquid reaction system, and also is a one-phase reaction system only containing the organic phase, for example, the halogen oxide radical is generated in the aqueous phase in the manner described above, the generated halogen oxide radical is dissolved (extracted) in the organic phase, the aqueous phase is then removed, and the organic phase containing the halogen oxide radical may be used, as said one-phase reaction system, for the surface treatment.

FIG. 2 schematically shows an example of the halogen oxide radical generation and the surface treatment using the two-phase reaction system. While FIG. 2 shows the chlorine dioxide radical as a specific example of the halogen oxide radical, the present invention is by no means limited by this example. As shown in FIG. 2, in the reaction system, two layers of an aqueous layer (the aqueous phase) and an organic layer (the organic phase) are separated in a reaction container, and are in contact with each other only at interfaces. An upper layer is the aqueous layer (the aqueous phase) 12, and a lower layer is the organic layer (the organic phase) 11. It is to be noted that, while FIG. 2 is a cross-sectional view, for viewability, hatching of the aqueous layer 12 and organic layer 11 is omitted. As shown in FIG. 2, chrolite acid ion (ClO₂·) in the aqueous layer (the aqueous phase) 12 reacts with an acid, thereby generating a chlorine dioxide radical (ClO₂⁻). Because the chlorine dioxide radical (ClO₂·) is water-insoluble, it dissolves in the organic layer 11. Subsequently, by irradiating the organic layer 11 containing the chlorine dioxide radical (ClO₂·) with light and applying light energy to the organic layer 11, the chlorine dioxide radical (ClO₂·) in the organic layer 11 is decomposed, thereby generating a chlorine radical (Cl·) and an oxygen molecule (O₂). Thus, graphene in the organic layer (organic phase) 11 is oxidized, and the surface is modified. It is to be noted, however, that FIG. 2 shows merely an illustrative example and by no means limits the present invention.

While the aqueous layer 12 is the upper layer and the organic layer 11 is the lower layer in FIG. 2, for example, if the organic layer 11 has lower density (specific gravity) than the aqueous layer 12, the organic layer 11 serves as the upper layer. For example, the graphene may be immobilized in the reaction vessel such that the graphene is placed in the upper organic layer. In this case, the site where the graphene is immobilized may be, for example, provided in the reaction vessel or may be provided outside the reaction vessel. In the latter case, for example, the graphene may be suspended from the outside and immersed in the organic layer.

Although FIG. 2 shows an example of the two-phase reaction system, the surface treatment may also be performed in a one-phase reaction system containing only an organic phase in the production method of the present invention. In this case, for example, an aqueous phase containing a source of the halogen oxide radical is prepared separately to generate the halogen oxide radical in the aqueous phase, the organic phase is then mixed with the aqueous phase to dissolve (extract), in the organic phase, the halogen oxide radical generated in the aqueous phase. Then, the aqueous phase and the organic phase are separated from each other, the organic phase is recovered, and the graphene is placed therein. Using this as a one-phase reaction system, the surface treatment is independently performed by light irradiation in the presence of the halogen oxide radical. When the reaction system in the surface treatment is the gas reaction system, as described above, the surface treatment may be performed in the gas reaction system after generation of the halogen oxide radical in the aqueous phase.

As a method of oxidizing the graphene surface, for example, there are a method of using a strong oxidizing agent such as potassium permanganate (KMnO₄), a method using plasma treatment in a gas phase, and a method using UV irradiation in an ozone-atmosphere. However, such a method does not stay with the oxidation of the graphene surface, but may cleave the carbon-carbon bond of the skeleton thereof and may decompose the graphene. In contrast, according to the surface treatment of the present invention, since the reaction can be performed under mild reaction conditions as described above, it is possible to suppress or prevent the cleavage of the carbon-carbon bond of the graphene skeleton. Further, according to the surface treatment of the present invention, it is easy to control the reaction conditions. Specifically, for example, the reaction in the surface treatment can be freely stopped by stopping the light irradiation, stopping the supply of the halogen oxide radical, or the like. Thus, for example, the cleavage of the carbon-carbon bond of graphene skeleton can be further suppressed, and, for example, the progress of the reaction of the graphene surface can be easily controlled. Therefore, according to the present invention, for example, it is possible to efficiently modify the graphene surface without decomposing graphene. The fact that the deterioration (decomposition, etc.) of graphene after the surface treatment is low can be verified by, for example, observing the graphene surface after the surface treatment by AFM (atomic force microscopy). Further, for example, in a treatment that requires several tens of minutes, such as oxidation in a liquid phase using potassium permanganate, ultraviolet (UV) irradiation in an ozone atmosphere, and the like, by using the surface treatment of the present invention, it also is possible to modify the graphene surface (oxidation reaction), for example by gas phase treatment (dry process), simply and in a short time (within a few minutes), while maintaining the graphene structure. Thus, for example, a functional group can be effectively introduced in the functional group introduction. This description, however, is merely an example, and does not limit the present invention. For example, the reaction system in the surface treatment of the present invention is not limited to the gas reaction system (gas phase treatment) as described above, and may be a liquid reaction system.

As described above, the method for producing a graphene grid according to the present invention, for example, can efficiently modify the graphene surface without decomposing graphene by the surface treatment. Thus, for example, as will be described below, the structural analysis target substance can be firmly immobilized at a high concentration to the surface of the cryo-electron microscopy, and uneven distribution (localization, e.g., flocculation, etc.), uneven orientation, and the like of the structural analysis target substance can be reduced or prevented. This makes it possible, for example, to dramatically reduce the time required for an optimization screening of measurement conditions for cryo-electron microscopy as compared with that of conventional methods. In addition, it is possible to reduce the time required for data collection for structural analysis.

### [2. Method for Producing Graphene Grid]

As described above, the method for producing a graphene grid according to the present invention (the production method of the present invention) is a method for producing a graphene grid having a graphene surface onto which a functional group containing a silicon atom is introduced, including functional group introduction that introduces the functional group containing a silicon atom by reacting a substituent in a surface of graphene having the substituent with a silane coupling agent. The substituent may be, for example, a substituent introduced through substituent introduction (surface treatment) using the halogen oxide radical. Hereinafter, the functional group introduction that introduces the functional group containing a silicon atom will be mainly described.

By introducing the functional group containing a silicon atom, various functions can be imparted to the graphene. Specifically, for example, as shown in the Examples to be described below, the functional group makes it easy to capture a structural analysis target substance (e.g., a protein) to be analyzed by cryo-electron microscopy. In addition, for example, by appropriately selecting the type of the functional group, any function corresponding to the type of the functional group can be imparted.

In the functional group introduction, for example, a functional group can be introduced onto an oxidized (modified) graphene surface onto which a substituent such as a hydroxy group, a carboxy group, or an aldehyde group (formyl group) has been introduced through a reaction (e.g., condensation reaction) between the substituent such as the hydroxy group, the carboxy group, or the aldehyde group and another substance. According to this, for example, any functional group that can be introduced through a reaction with the substituent (e.g., a hydroxy group, a carboxy group, an aldehyde group, or the like) having been introduced onto the graphene surface can be introduced. As described above, said another substance may be, for example, a silane coupling agent or the like.

In the present invention, a molecular structure of the silane coupling agent is not particularly limited, and for example, a general silane coupling agent may be appropriately used. In the present invention, the molecular structure of the silane coupling agent may be as shown in the following chemical formula (I).

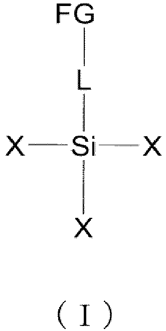

In the chemical formula (I), examples of X include a halo group (halogen), an alkoxy group, a hydroxy group, an alkyl group, an amino group, and an aryl group, and X may each be mutually identical or different. Examples of the halo group (halogen) include a fluoro group (fluorine atom), a chloro group (chlorine atom), a buromo group (bromine atom), and an iodo group (iodine atom). Examples of the alkoxy group include a methoxy group, an ethoxy group, and a propoxy group.

In the chemical formula (I), FG represents a functional group and is not particularly limited. Examples of FG include a hydroxy group, a carboxy group, an aldehyde group, a carbonyl group, an ether bond, an epoxy group, an ester bond, an amino group, an imino group, a maleimide group, a sulfonyl group, a sulfonyloxy group, a fluoroalkyl group, a cyano group, an isocyanato group (isocyanate group), a vinyl group, a styryl group, a methacrylic group, an acrylic group, an ureido group, a mercapto group, an isothiocyanate group, an azido group, an ethyl group, an imidoester group, a halide, an activated carboxy group (examples are not particularly limited, and can be an NHS ester group, an acid chloride, an acide anhydride, a fluoro ester or the like).

In the chemical formula (I), L represents an atom group (connecting group) connecting a silicon atom Si and FG, or is absent. L may or may not contain a hetero atom, and may be linear or branched, and may or may not include a cyclic structure. The number of atoms forming L is not particularly limited and may be, for example, 0 to 3, 0 to 5, 0 to 12, 0 to 30, or the like. L may be, for example, a 1-3C, 1-4C, 1-7C, or 1-10C linear or branched alkylene group, and for example, a methylene group, an ethylene group (dimethylene group), a trimethylene group, a tetramethylene group, a pentamethylene group, a hexamethylene group, a heptamethylene group, an octamethylene group, or the like. In the linear or branched alkylene group, for example, one or more methylene groups may be substituted with an ether group (-O-), a thioether group (-S-), an imino group (-NH-), a carbonyl group (-CO-), or an ester group (-COO-). Note that, in the present invention, a "hetero atom" refers to an atom other than carbon or hydrogen, and examples thereof include oxygen, sulfur, selenium, nitrogen, and silicon.

A structure of the graphene grid of the present invention is not particularly limited and may be, for example, as shown in the following chemical formula (II).

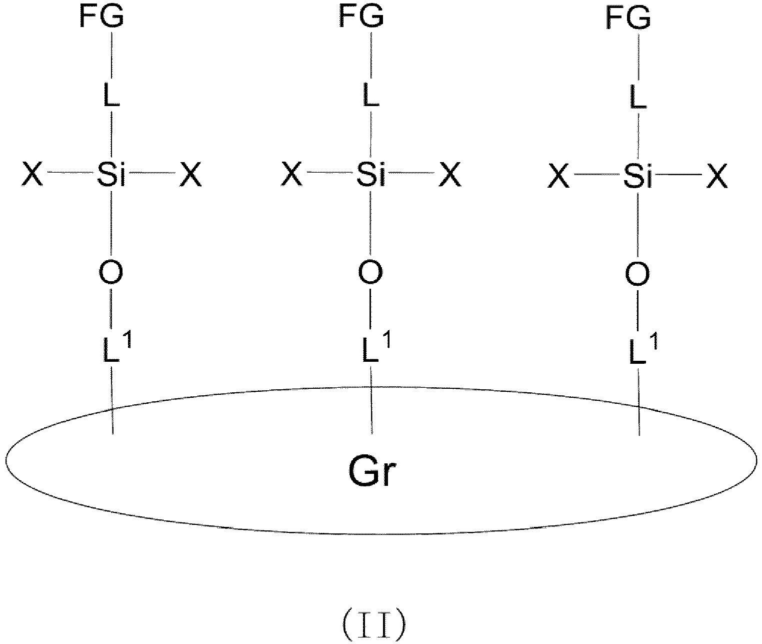

In the chemical formula (II), Gr represents graphene. X, FG, and L are the same as in the chemical formula (I). X may each be mutually identical or different, FG may each be mutually identical or different, and L may each be mutually identical or different. L¹ represents an atom group (connecting group) connecting graphene and an oxygen atom O, or does not exist, and L¹ may each be mutually identical or different. When L¹ is present, L¹ may or may not include a hetero atom, and may be linear or branched, and may or may not include a cyclic structure. The number of atoms forming L¹ is not particularly limited and may be, for example, 0 to 2, 0 to 5, 0 to 10, 0 to 50, or the like. L¹ may be, for example, a carbonyl group, a ketone group, an ether bond, an ester bond, or the like. L¹ may be, for example, a 1-24C, 1-18C, 1-12C, or 1-6C linear or branched alkylene group or the like, and for example, a methylene group, an ethylene group (dimethylene group), a trimethylene group, a tetramethylene group, a pentamethylene group, a hexamethylene group, a heptamethylene group, an octamethylene group, or the like. In the linear or branched alkylene group, for example, one or more methylene groups may be substituted with an ether group (-O-), a thioether group (-S-), an imino group (-NH-), or a carbonyl group (-CO-).

Note that, in the chemical formula (II), the number of each of X, FG, L and L¹ is 3. However, these are shown schematically but practically exist in multiple numbers. The same applies to cases in the presenst invention where a substituent or a functional group exists on graphene.

The graphene grid of the present invention may have, for example, a hydroxyl group instead of a substituent X in the chemical formula (II). For example, when a substituent X of a silane coupling agent is a halo group or an alkoxy group, the substituent X may be converted into a hydroxyl group by hydrolyzation. In a structure of the graphene grid of the present invention, for example, as shown in the following chemical formula (III), adjacent silicons may be bonded to each other with ether bonds. In the following chemical formula (III), Gr, X, FG, L, and L¹ are the same as in the chemical formula (II).

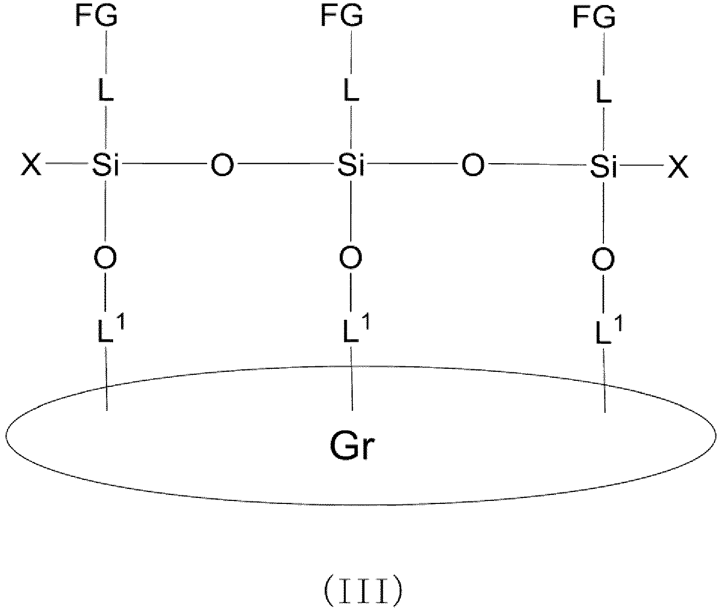

Note that, in the graphene grid of the present invention, a "functional group containing a silicon atom" refers to, for example in the chemical formulra (II) or (III), the rest of the part excluding the graphene, or the rest of the part excluding the graphene and L¹.

In the present invention, a molecular structure of a phosphonic acid derivative is not particularly limited. As the phosphonic acid derivative, for example, a general phosphonic acid derivative used for the same purpose as a silane coupling agent may be appropriately used. In the present invention, the molecular structure of the phosphonic acid derivative may be, for example, as shown in the following chemical formula (IV).

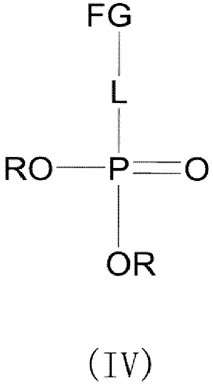

In the chemical formula (IV), R represents a hydrogen atom, an alkyl group or an aryl group for example, and R may each be mutually identical or different. L and FG are, for example, the same as in the chemical formula (I).

A structure of the graphene grid of the present invention is not particularly limited as described above and may by, for example, as shown in the following chemical formula (V).

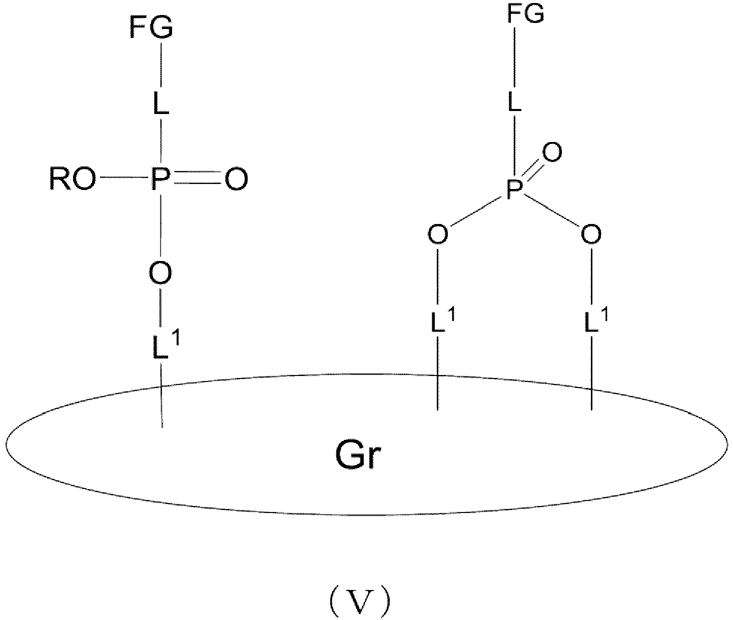

In the chemical formula (V), R, L, and FG are the same as in the chemical formula (IV), and Gr and L¹ are the same as in the chemical formula (II) or (III).

Note that, in the present invention, a silane coupling agent and a phosphonic acid derivative may be privately composed, or a commercial product may be used as it is. Further, for example, each of a silane coupling agent and a phosphonic acid derivative commercially available in a state of a solution or a dispersion liquid may be used as it is for a reaction in the functional group introduction

In the method for producing a graphene grid according to the present invention, the functional group introduction involves introducing the functional group containing a silicon atom by reacting a substituent on a surface of graphene having the substituent with at least one of a silane coupling agent or a phosphonic acid derivative, as described above. The following scheme A schematically shows an example of the functional group introduction. The following scheme A is an example in a case where the substituent is a hydroxyl group. In the following scheme A, for example, R represents an alkyl group (e.g., a methyl group, an ethyl group, and the like), FG represents a functional group similarly to the chemical formulae (I), (II) and (III). A silicon atom and the functional group FG are directly bonded in the following scheme A, but may be bonded via the connecting group L, as described above.

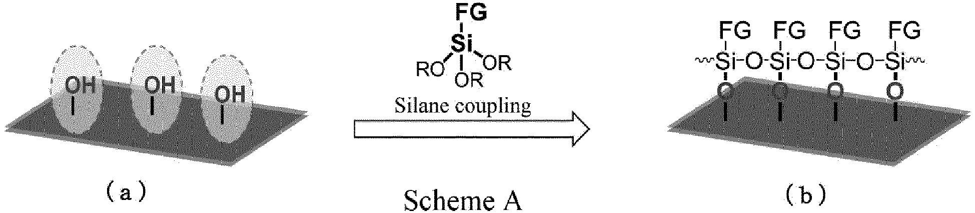

The following chemical formula shows an example of each of a silane coupling agent having an amino group as the functional group FG, a silane coupling agent having an epoxy group as the functional group FG, a silane coupling agent having an isocyanate group as the functional group FG, and a silane coupling agent having a carboxy group as the functional group FG. It is to be noted, however, that the present invention is by no means limited to the illustrated examples.

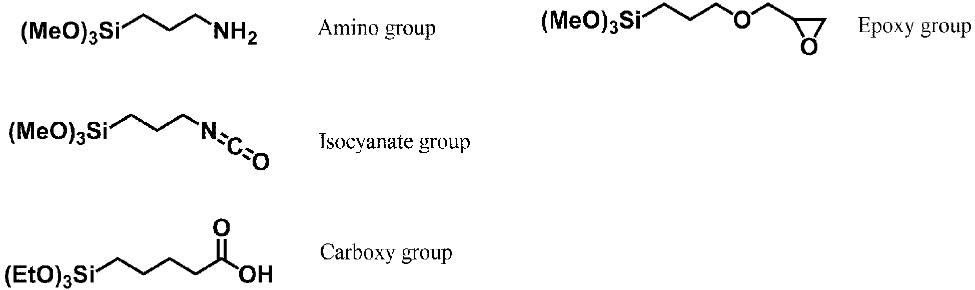

Reaction conditions of the functional group-introduction are not particularly limited and maybe freely set. Hereinafter, reaction conditions when using a silane coupling agent in the functional group introduction are mainly described. However, when using a phosphonic acid derivative in addition to or instead of the silane coupling agent, reaction conditions same as or based on the reaction conditions may be applied. Reaction conditions in the functional group introduction may be, for example, the same as or based on a reaction of a general silane coupling agent. The reaction conditions may be the same as or based on that in the same or similar existing reaction. For example, when introducing a functional group by a reaction of a hydroxyl group or a carboxy group with a silane coupling agent, reaction conditions the same as or based on that in an existing reaction of a hydroxyl group or a carboxy group with a silane coupling agent may be applied.

Specifically, the functional group introduction may be, for example, performed as described below. Firstly, graphene having a surface with a substituent is prepared. The graphene having the surface with the substituent may be, for example, graphene onto which a substituent has been introduced through the surface treating (substituent introduction) described above. The substituent is not particularly limited and may be, for example, a hydroxyl group, a carboxy group, an aldehyde group, or the like, as described above.

Thereafter, a silane coupling agent is brought into contact with the surface with the substituent in the graphene having the surface with the substituent. At this time, the silane coupling agent may be used as a solution by being dissolved in a solvent, or as a dispersed liquid by being dispersed in a dispersion medium. The solvent and the dispersion medium are not particularly limited and may be, for example, water, an organic solvent, or a mixture of water and the organic solvent. The organic solvent is not particularly limited and examples thereof include alcohols such as methanol, ethanol, isopropyl alcohol, butanol, ethylene glycol, diethylene glycol, triethylene glycol, propylene glycol, and benzyl alcohol; ketones such as acetone, ethyl methyl ketone, methyl isobutyl ketone, diisobutyl ketone, cyclohexanone, and diacetone alcohol; ethers such as diethyl ether, tetrahydrofuran, 1,4-dioxane, methyl tert-butyl ether, and ethyl ethoxypropionate; esters such as ethyl acetate, butyl acetate, propyl acetate, isopropyl acetate, methyl lactate, ethyl lactate, butyl lactate, and 3-methoxy-3-methylbutyl acetate; hydrocarbons such as benzene, toluene, xylene, terpenes, i-paraffines, n-paraffines, a naphthene-based metal detergent, an aromatic solvent, and n-hexane; amines such as N-methyl-2-pirrolidone, dimethylformamide, and N,N-dimethylacetamide; halogen-based solvents such as dichloromethane, chloroform, trichloroethylene, perchloroethylene, and bromopropane, and one kind thereof may be used, or two or more kinds thereof may be used in combination. When mixing two or more kinds of the solvent or the dispersion liquid, the mixing ratio is not particularly limited and may be appropriately set, for example, depending on solubility of the silane coupling agent, the boiling point of the solvent, or the like. For example, water and an alcohol (e.g., methanol, ethanol, and the like) may be mixed at an appropriate ratio to be used. The concentration of the silane coupling agent in the solution or the dispersion liquid is not particularly limited and may be, for example, 25 mmol/L or more, 15 mmol/L or more, 10 mmol/L or more, 5 mmol/L ore more, or 1 mmol/L or more, and for example, 25 mmol/L or less, 15 mmol/L or less, 10 mmol/L or less, 5 mmol/L or less, or 1 mmol/L ore less. The amount of the solution or the dispersion liquid to be used is not particularly limited either, and the number of mols of the silane coupling agent per 1 mm² of a surface area of the graphene may be, for example, 25 mmol or more, 15 mmol or more, 10 mmol or more, 5 mmol or more, or 1 mmol or more, and for example, 25 mmol or less, 15 mmol or less, 10 mmol or less, 5 mmol or less, or 1 mmol or less.

Then, the graphene having the surface with the substituent is left to stand for a while in a state where the surface with the substituent is in contact with a silane coupling agent so that the graphene reacts with the silane coupling agent. As such, for example, the substituent in the graphene surface and the silane coupling agent may be bonded to each other. The reaction temperature of the reaction is not particularly limited and may be, for example, 130°C or more, 120°C or more, 100°C or more, 80°C or more, or 70°C or more, and for example, 130°C or less, 120°C or less, 100°C or less, 80°C or less, or 70°C or less. The reaction time of the reaction is not particularly limited and may be, for example, 30 minutes or more, 20 minutes or more, 15 minutes or more, 10 minutes or more, or 5 minutes or more, and for example, 30 minutes or less, 20 minutes or less, 15 minutes or less, 10 minutes or less, or 5 minutes or less. In this way, the functional group introduction is performed to react the substituent with a silane coupling agent and introduce the functional group containing a silicon atom, thereby producing the graphene grid of the present invention. Note that after the reaction, for example, an excessive silane coupling agent remained on the graphene grid surface may be removed by washing with a solvent, a dispersion liquid, or the like. The solvent or the dispersion liquid for the washing is not particularly limited and may be the same as the solvent or the dispersion liquid for the reaction.

The functional group introduction may be as described below with reference to the Examples. Other than these, the functional group introduction may be, for example, introducing an epoxy group using a silane coupling agent containing a 2,3-epoxypropyl group, and performing an addition reaction between the epoxy group and a protein, a 1H,1H-undecafluorohexylamine, or the like. The 1H, 1H-undecafluorohexylamine is not limited thereto and may be any other amine. The amine is not particularly limited and may be, for example, the primary or secondary amine. The present invention is not limited thereto, and may be freely performed without departing from the scope of the present invention.

A functional group to be introduced through the functional group introduction is not particularly limited and may be, for example, any functional group which can be introduced by a reaction with the substituent (e.g., a hydroxyl group, a carboxy group, an aldehyde group, and the like) introduced in the graphene surface, as described above. As described above, the functional group to be introduced through the functional group introduction may be, for example, at least one selected from the group consisting of a hydroxy group, a carboxy group, an aldehyde group, a carbonyl group, an ether bond, an epoxy group, an ester bond, an amino group, an imino group, a maleimide group, a sulfonyl group, a sulfonyloxy group, a fluoroalkyl group, a cyano group, an isocyanato group (isocyanate group), a vinyl group, a styryl group, a methacrylic group, an acrylic group, a ureido group, a mercapto group, an isothiocyanate group, an azido group, an ethynyl group, an imidoester group, a halide, and an activated carboxy group (the group is not particularly limited, and can be an NHS ester group, an acid chloride, an acid anhydride, a fluoro ester, or the like). The fluoroalkyl group may be a group obtained by substituting a part of or a whole hydrogen atom of an alkyl group with a fluorine atom, and may be, for example, a perfluoroalkyl group obtained by substituting a whole hydrogen atom of an alkyl group with a fluorine atom, and for example, a trifluoromethyl group. The functional group may be, for example, a combination of two or more functional groups, and may be, for example, a trifluoroacetyl group which is a combination of a trifluoromethyl group and an ester bond, or may be, for example, a trifluoromethyl sulfonyl group which is a combination of a trifluoromethyl group and a sulfonyl group. Note that, in the present invention, the carbon number of an "alkyl group" is not particularly limited and may be, for example, 1 to 24, 1 to 18, 1 to 12, 1 to 6, or the like, and the "alkyl group" may be linear or branched.The same applies to a group obtained by substituting at least one hydrogen atom of an alkyl group (e.g., a fluoroalkyl group), a group partially containing an alkyl group (e.g., an alkoxy group, an alkanoyl group), a group derived from an alkyl group (e.g., an alkylene group), and the like. Specific examples of a functional group to be introduced through the functional group introduction include a succynimidyl group, an isothiocyano group, a sulfonic acid chloride group, a carboxylic acid chloride group, an ethylene oxide group, an alkyl chloride group, a carboxylic acid anhydride group, a maleimide group, a hydrazide, and the like, and these functional groups can be reacted with a substituent such as a hydroxyl group, a carboxy group, an aldehyde group, and the like on the graphene surface so as to be introduced onto the graphene surface. The introduced functional group can be reacted with, for example, a group such as an amino group, a sulfhydryl group (also referred to as -SH, a mecapto group, a thiol group) and an aldehyde grop, and thus can be captured by being bonded to a compound containing these groups (e.g., a protein or the like).

Generally, a silane coupling agent easily reacts and can form a strong bond even with an inorganic material. Thus, a silane coupling agent also easily reacts and can form a strong bond with reaction groups such as a hydroxyl group, a carboxy group, and the like introduced onto the graphene surface. Also, for example, the "functional group introduction" that introduces the functional group containing a silicon atom by reacting a substituent on a graphene surface with a silane coupling agent can be performed in a simple manner under mild reaction conditions. Further, a silane coupling agent can have a wide variety of structures, and specifically, for example, can have a wide variety of functional groups described above. For this, the production method of the present invention achieves, for example, introduction of a wide variety of functional groups onto a graphene grid. When using a graphene grid produced by the production method of the present invention as a grid for cryo-electron microscopy, it is possible to handle a wide variety of structural analysis target substances.

The use of a phosphonic acid derivative in the functional group introduction can provide the same advantages as described above in the use of a silane coupling agent. Further, the use of a phosphonic acid derivative, for example, possibly provides advantages such as being more resistant to hydrolyzation and thus providing stability, easily bonding to a substituent on a graphene surface more strongly, and the like, compared to that of a silane coupling agent. However, this description is merely an example and the present invention is by no means limited thereto.

The graphene grid produced by the production method of the present invention can be used, for example, as a grid for cryo-electron microscopy. For example, during the structural analysis by cryo-electron microscopy, a structural analysis target substance to be analyzed by cryo-electron microscopy can be bonded to the grid for cryo-electron microscopy (graphene grid) produced by the production method of the present invention. The grid for cryo-electron microscopy produced by the production method of the present invention may be a graphene grid to which a structural analysis target substance to be analyzed by cryo-electron microscopy is bonded, or may be a graphene grid to which a structural analysis target substance to be analyzed by cryo-electron microscopy is not bonded.

### [3. Graphene Grid (e.g. Grid for Cryo-Electron Microscopy)]

As described above, the graphene grid of the present invention includes a graphene surface onto which a functional group containing a silicon atom is introduced. The graphene grid of the present invention can be used, for example, as a grid for cryo-electron microscopy. For example, during the structural analysis by cryo-electron microscopy, a structural analysis target substance to be analyzed by cryo-electron microscopy can be bonded to the grid for cryo-electron microscopy (graphene grid) of the present invention. Further, as described above, the graphene grid of the present invention may be, for example, a grid for cryo-electron microscopy obtained by binding a structural analysis target substance to be analyzed by cryo-electron microscopy to the graphene grid of the present invention. The grid for cryo-electron microscopy of the present invention may be a graphene grid to which a structural analysis target substance to be analyzed by cryo-electron microscopy is bonded, or may be a graphene grid to which a structural analysis target substance to be analyzed by cryo-electron microscopy is not bonded.

The method for producing a graphene grid according to the present invention is not particularly limited, and the graphene grid can be produced, for example, by the method for producing a graphene grid according to the present invention described above. This production method includes the functional group introduction, as described above. Also, as described above, the production method of the present invention may further include the surface treatment (substituent introduction).

Further, for example, it is also possible to produce a graphene grid of the present invention by performing the functional group introduction on the graphene without performing the surface treatment. More specifically, for example, if the graphene surface that is not subjected to the surface treatment has substituents such as a hydroxy group, a carboxy group, and the like, the graphene grid of the present invention can be produced by performing the functional group introduction on those substituents.

In the graphene grid of the present invention, for example, by bonding a structural analysis target substance to be analyzed by cryo-electron microscopy to the functional group, it is possible to reduce or prevent uneven distribution, uneven orientation, and the like of the structural analysis target substance. Further, as described above, the graphene grid of the present invention may be, for example, used as a grid for cryo-electron microscopy by bonding a structural analysis target substance to be analyzed by cryo-electron microscopy to the functional group. Note that, in the present invention, a "bond" is not particularly limited and may be, for example, a chemical or physical bond. In the presnet invention, the "bond" may be, for example, a covalent bond, an ion bond, or the like, and may be a hydrogenn bond or other various interactions, but not limited thereto. In the present invention, examples of the "bond" include, a covalent bond, an ion bond, a metal-coordinate bond, a host-guest interaction, a hydrogen bond, a bond occurred by Van der Waals' forces, a dipole-dipole interaction, a cation-π interaction, an anion-π interaction, and a halogen bond. In the graphene grid of the present invention, a bond between the functional group and the structural analysis target substance is not particularly limited and may be any among the above-described types of bonds, and examples thereof include a covalent bond, an ion bond, a metal-coordinate bond, a host-guest interaction, a hydrogen bond, a bond occurred by Van der Waals' forces, a dipole-dipole interaction, a cation-π interaction, an anion-π interaction, and a halogen bond. Among these examples, the covalent bond is particularly preferable from the viewpoint of the strength of the bond.

In the graphene grid of the present invention, a structural analysis target substance to be analyzed by cryo-electron microscopy is covalently bonded to the functional group, which provides the following advantages. First, when the structural analysis target substance is bonded to the functional group by a covalent bond, the structural analysis target substance is less likely to fall off even when the surface of the cryo-electron microscopy is washed. Therefore, by the washing, it is possible to wash off unnecessary impurities (e.g., proteins denatured at the gas-liquid interface) which are not covalently bonded to the surface of the cryo-electron microscope., which allows structural analysis with high accuracy. Second, even if the structural analysis target substance is a substance that is difficult to concentrate (e.g., a protein that is difficult to concentrate, etc.), the structural analysis target substance can be introduced onto the surface of the cryo-electron microscope at a high concentration by repeatedly forming a covalent bond to the functional group. As a result, for example, it is possible to dramatically reduce the time required for optimization screening of measurement conditions for cryo-electron microscopy and data collection for structural analysis. Third, since the structural analysis target substance can be firmly immobilized to the surface of the cryo-electron microscopy by the covalent bond, uneven distribution (localization, e.g., flocculation, etc.), uneven orientation, and the like of the structural analysis target substance can be reduced or prevented. Therefore, it is possible to analyze the structural analysis target substance with high accuracy and high resolution. Fourth, for example, by having the first to third features, for example, as demonstrated in the Examples to be described below, it is possible to analyze the structural analysis target substance with high accuracy and high resolution even without introducing a tag or the like onto the structural analysis target substance (e.g., a protein). Since the process of introducing a tag or the like onto the structural analysis target substance becomes unnecessary, the measurement sample (the grid for cryo-electron microscopy of the present invention to which the structural analysis target substance is bonded) can be easily produced in a short time. Thus, according to the present invention, for example, it is possible to dramatically reduce the time for preparing a measurement sample for cryo-electron microscopy as compared with that of a conventional one, and it is possible to prepare the measurement sample by an operation easier than that of a conventional method. The present invention, however, is not limited to an aspect of not introducing a tag or the like onto the structural analysis target substance, and the structural analysis may be conducted by introducing a tag or the like onto the structural analysis target substance (e.g., a protein).

Since conventional carbon grids for cryo-electron microscopy have a weak binding force between the grid and the structural analysis target substance, as described above, it was possible that uneven distribution (localization), uneven orientation, and the like of the structural analysis target substance on the carbon grid to occur, which may hinder the structural analysis. In contrast, the graphene grid of the present invention can strongly bond the structural analysis target substance as described above. Thereby, uneven distribution, uneven orientation, and the like of the structural analysis target substance can be reduced or prevented.

The method of bonding the structural analysis target substance to the functional group is not particularly limited. For example, depending on the combination of the functional group and the structural analysis target substance, the same or similar reaction conditions as those of known similar reactions can be appropriately set. For example, the graphene grid of the present invention having the functional group may be immersed in a solution (e.g., an aqueous solution) of the structural analysis target substance for an appropriate time, however, the present invention is not limited to this method.

The structural analysis target substance is not particularly limited, and may be, for example, the same as or different from a general structural analysis target substance of cryo-electron microscopy. Examples of the structural analysis target substance include proteins, antibodies, nucleic acids, viruses, ribosomes, mitochondria, ion channels, enzymes, and enzyme complexes. Examples of the protein include, in the case of classifying by physical properties, membrane proteins, water-soluble proteins, and glycoproteins, and include, in the case of classifying by functions, enzymatic proteins, structural proteins, transcription factors, transporting proteins, storage proteins, contractile proteins, and protection proteins. Examples of the protein include, besides apoferritin used as a reference protein for analysis, ribosomes, proteasomes, RNA polymerases, capsids, GPCR, photochemical complexes, ATP synthetases, and complexes with antibodies. In addition to them, tubulin or the like composed of these can be the structural analysis target substance in the present invention. Further, examples of the structural analysis target substance in the present invention include tissue itself such as muscle, collagen, and flagella. Moreover, for example, a living body itself, a tissue surface, or the like can be used as the structural analysis target substance in the present invention by using an antibody or the like, as a labeled protein.

The graphene grid of the present invention can reduce or prevent the uneven distribution, uneven orientation, and the like of the structural analysis target substance as described above. Further, the grid for cryo-electron microscopy of the present invention can analyze the structure of a substance that has been difficult to analyze by a conventional grid for cryo-electron microscopy. For example, since a membrane protein and the like are difficult to crystallize, it has been difficult to analyze the three-dimensional structure of the membrane protein by a conventional grid for cryo-electron microscopy. In contrast, since the graphene grid of the present invention can strongly bond to a structural analysis target substance such as the membrane protein to stabilize the structure, the structural analysis can be performed, and for example, three dimensional structural analyses can be performed. Further, the graphene grid of the present invention can perform, for example, a single particle analysis of a protein or the like.

The usage of the graphene grid of the present invention is not particularly limited, and may be, for example, the same method as that of a general grid for cryo-electron microscopy. For example, similar to a general grid for cryo-electron microscopy, a structural analysis can be performed by observing the captured structural analysis target substance by microscopy using the Vitreous Ice Embedding method.

In the present invention, for example, as described above, it is possible to conduct structural analysis with high accuracy and high resolution without adding a tag or the like to a protein. However, as described above, the present invention is not limited to introducing without a tag or the like onto the structural analysis target substance, and the structural analysis may be conducted by introducing a tag or the like onto the structural analysis target substance (e.g., a protein).

Further, the use of the graphene grid of the present invention is not limited to a grid for cryo-electron microscopy, and can be used in any wide range of applications, and can be used, for example, in applications such as a bioreactor, a sensor (e.g., a biosensor such as an enzyme sensor), a microreactor, and the like, and also in detection reagents when an antibody or various proteins are linked to a bead or the like, affinity column chromatography, and the like. Examples

Next, examples of the present invention will be described below. It is to be noted, however, that the present invention is by no means limited to the following examples.

### Reference Example 1

As described below, a graphene surface was modified through the surface treatment of the present invention to introduce a substituent, thereby a substance with a modified graphene surface was produced.

In the present reference example, the surface treatment using a reaction in a gas phase was performed.

First, as shown in FIG. 1, 20 mL of deionized water was added to a 5-cm-diameter petri dish 3, and then sodium chlorite (NaClO₂)(300mg) and a 36% by mass HCl aqueous solution (100 µL) were dissolved to obtain a hydrochloric acid acidic NaClO₂ aqueous solution (radical generation reaction system) 5. On the other hand, 10 mg of the graphene 6 was placed in a 3-cm-diameter petri dish 4. These petri dishes 3 and 4 were housed in a 11-cm-diameter petri dish 1. In addition, a lid 2 was placed on the petri dish 1 to prevent gas inside the petri dish 1 from leaking. Thereafter, the hydrochloric acid acidic NaClO₂ aqueous solution 5 in the petri dish 3 was irradiated from above the petri dish 1 with an LED light having a wavelength of 365 nm for 3 minutes, 10 minutes, 30 minutes, or 60 minutes at room temperature and at a light amount of 10 mW/cm². By this light irradiation, a gas of ClO₂ radicals generated by the reaction of hydrochloric acid and NaClO₂ in the petri dish 3 and flowed into the petri dish 4 was activated, and was reacted with the graphene 6. By this surface treatment, a surface of the graphene 6 was oxidized. The graphene 6 after oxidation was dried under reduced pressure for 24 hours to obtain a target object (a substance with a modified graphene 6 surface).

In the present example, as the graphene 6, a substance obtained by modifying the surface of the graphene 6 was produced using powdered graphene (produced by FUJIFILM Wako Pure Chemical Corporation., trade name: "06-0313 ").

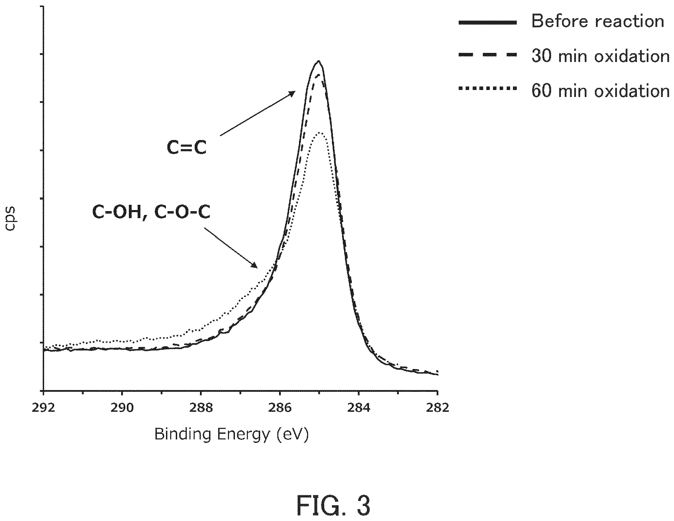

The progress of the oxidation reaction in the graphene 6 was examined by X-ray photoelectron spectroscopy (XPS) measurement before and after the surface treatment (oxidation reaction) to detect the energy-peak position of C1s (1s orbital of carbon atom). The results of the XPS measurement are shown in the graph of FIG. 3. In FIG. 3, the horizontal axis indicates the binding energy (eV), and the vertical axis indicates the relative value of the peak intensity (cps).

As described above, FIG. 3 shows the XPS measurement results before and after the surface treatment (oxidation reaction) of graphene. As shown in FIG. 3, there was no major change in 30 minutes after the reaction, but decrease in the C=C bond peak, and increase in the C-OH bond peak and C-O-C bond peak were observed in 60 minutes after the reaction, whereby oxidation of the graphene surface was verified. Further, elemental analysis results by the XPS are summarized in Table 1 below. As summarized in Table 1, the ratio of the number of O atoms was increased after the oxidation reaction, which also verifies the oxidation of the graphene surface.

**[Table. 1]**

| Element ratio in graphene | | |
|---|---|---|
| | O | C |
| Before reaction | 5.4 | 94.6 |
| 30 min after oxidation reaction | 8.3 | 91.6 |
| 60 min after oxidation reaction | 11.4 | 87.8 |

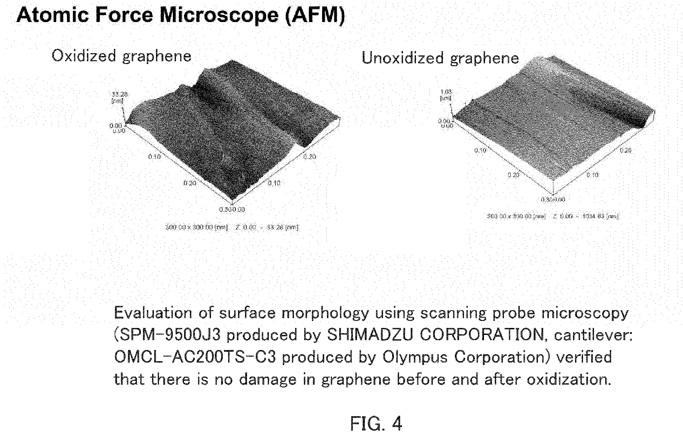

In addition, the state of each graphene surface before and after the surface treatment (oxidation reaction) was observed by AFM (atomic force microscopy). Specifically, the surface morphology was evaluated using a scanning probe microscopy (trade name: SPM-9500J3, produced by Shimadzu Corporation, with Cantilever: OMCL-AC200TS-C3 (trade name), produced by Olympus Corporation). The results are shown in FIG. 4. As shown in FIG. 4, according to the evaluation by AFM, no damage or the like of the graphene by the surface treatment (oxidation reaction) was observed, and no deterioration of the graphene was observed.

Further, it is presumed that, for example, the structure of the graphene surface after oxidation in the present reference example is as shown by the following chemical formula E1. However, this structure is only an example of a presumable structure.

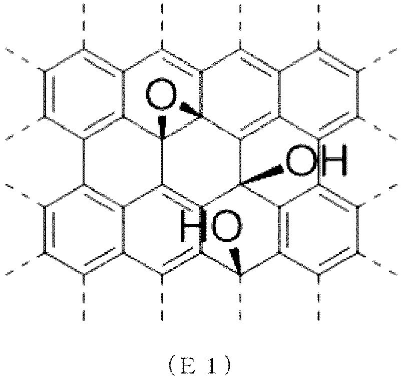

### [Reference Example 2]

Rhodamine B was bonded to the graphene of Reference Example 1 in the following manner, and the fluorescence intensity was measured.

First, 6 mg of Rhodamine B was added to a test tube. Next, 2 mL of deionized water was added thereto, and then a 0.1 M acetic acid aqueous solution was added to adjust to a pH of 6.5. Two of these were prepared, and the graphene before the oxidation reaction and graphene after 60 minutes of the oxidation reaction were added to each, respectively, and stirred at room temperature for 15 minutes. After each reaction, the resultant was washed twice using 3 mL of deionized water and dried under reduced pressure for 24 hours. Thereafter, the fluorescence intensity of each resultant was measured using a UV-vis spectrometer with the excited light at 555 nm in the range from 560 to 660 nm.

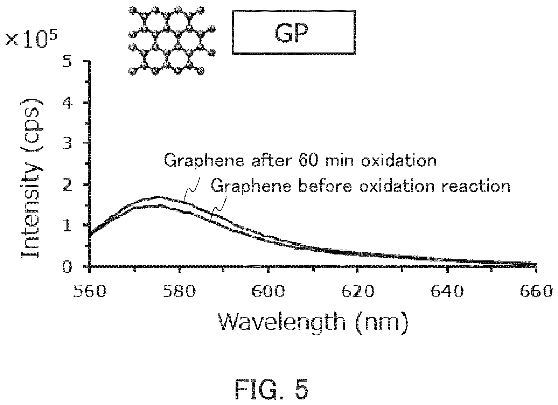

FIG. 5 shows the results of fluorescence intensity measurement of the graphene. In FIG. 5, the horizontal axis indicates the wavelength (nm), and the vertical axis indicates the peak intensity (relative value). As shown in FIG. 5, the peak intensity at around 575 nm of graphene was increased after the oxidation reaction, which verified that rhodamine B was bonded thereto. From this fact, it was inferred that a hydroxy group or a carboxy group or both of them have been introduced onto the surface of the graphene after the oxidation reaction.

### [Reference Example 3]

A graphene grid was produced. The graphene grid was subjected to surface modification (substituent introduction) to introduce a substituent thereon, by being reacted with a chlorine dioxide radical through surface treatment to modify (oxidize) the graphene grid surface. As a result, a graphene grid having a modified (oxidized) surface is produced.

### [Production of Graphene Grid]

A sheet composed of three layers of polymethyl methacrylate (PMMA)-graphene-Cu was allowed to float such that the Cu surface was brought into contact with the water surface of a 0.5 mol/L ammonium persulfate aqueous solution, and the Cu layer was dissolved by standing still for 30 minutes. The PMMA-graphene sheet thus obtained by removing the Cu layer was allowed to float and washed in ultrapure water for a total of two times for 10 minutes. Thereafter, a Mo grid (produced by Quantifoil Micro Tools GmbH, trade name: QUANTIFOII,) or an Au grid (produced by Quantifoil Micro Tools GmbH, trade name: QUANTIFOII,) for TEM were placed at the bottom of a film tensioner (produced by Okenshoji Co., Ltd., trade name: COLLISION FILM TENSIONER) filled with ultrapure water. Further, by floating the PMMA-graphene sheet on the water surface of the film tensioner and gently draining the water, the PMMA-graphene sheet was adhered to the grid. The grid was dried for 1 hour at room temperature, and heat treatment was performed for 20 minutes at 130°C. Thereafter, the grid was immersed in acetone at 60°C for 60 minutes, chloroform at room temperature (about 25°C) for 30 minutes, acetic acid for 3 hours, and isopropyl alcohol for 10 minutes in a total of twice to remove PMMA. Finally, heat treatment was performed at 100°C for 10 minutes to produce a graphene grid with a Mo grid or Au grid surface coated with graphene.

### [Reaction between Graphene Grid and Chlorine Dioxide Radical (Surface Treatment)]

Each of the graphene grids produced from the Mo grid and Au grid was subjected to heat treatment at 130°C for 15 minutes. After the heat treatment, the graphene grid was subjected to the (surface oxidation) by a chlorine dioxide radical (ClO₂ radical) in the same manner as described in Reference Example 1 and FIG. 1. In the present example however, the graphene grid was covered with aluminum foil and the surface treatment (surface oxidation) was performed so that the LED light (UV light) did not directly hit the graphene grid. The reaction time (light irradiation time) was set to 10 minutes, and the reaction temperature was set to room temperature as in Reference Example 1. The XPS measurement was performed on the graphene grids before and after the surface treatment in the same manner as in Reference Example 1. As a result, the decrease in the C=C bond peak, the increase in the C-OH bond peak, and the increase in the C-O-C bond peak were observed after the surface treatment, and further, the ratio of the number of O atoms was increased, which verified the oxidation of the graphene surface.

### [Reference Example 4]

As described below, the graphene grid surface was modified through the surface treatment of the present invention to produce a substance with a modified graphene grid surface.

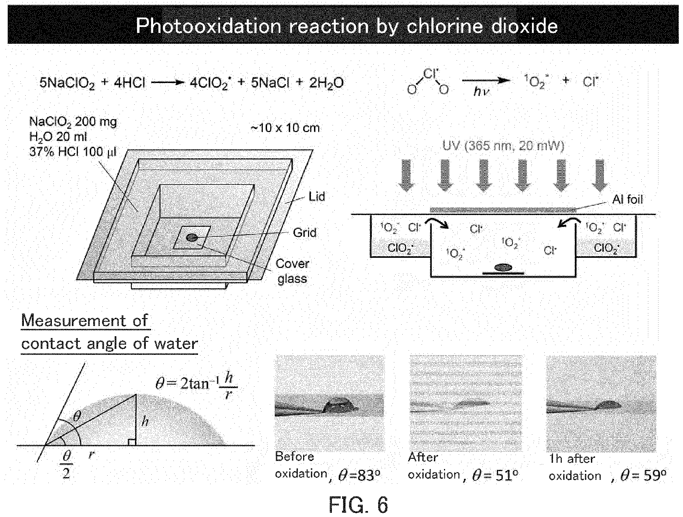

First, sodium chlorite NaClO₂ (200 mg) was dissolved in 20 mL of ultrapure water, and then a 37% by mass HCl aqueous solution (100 µL) was added to prepare a 1% by mass hydrochloric acid NaClO₂ aqueous solution (radical generation reaction system). Subsequently, as shown in FIG. 6, the hydrochloric acid NaClO₂ aqueous solution was added to the outer container of a 10 cm × 10 cm glass double walled container (petri dish). Meanwhile, a cover glass was placed in the inner container of the glass double walled container, and a graphene grid produced by the method of Reference Example 3 was placed on the cover glass. Further, the glass double walled container was covered with a lid to prevent gas inside from leaking. Thereafter, the hydrochloric acid NaClO₂ aqueous solution in the glass double walled container was irradiated with LED light having a wavelength of 365 nm from above the glass double walled container at a light amount of 20 mW/cm² for 10 minutes at room temperature. At this time, as shown in FIG. 6, the upper side of the inner container was covered with an aluminum foil from above the lid so that the graphene grid was not directly exposed to light. By this light irradiation, a ClO₂ radical gas generated by the reaction of hydrochloric acid and NaClO₂ in the petri dish 3 and flowed into the petri dish 4 was activated, and reacted with the graphene 6. By this surface treatment, the graphene grid surface was oxidized. The graphene grid after oxidation was dried under reduced pressure for 24 hours to obtain a target object (a substance with a modified graphene grid surface).

As shown in the lower part of FIG. 6, a water drop was dropped on the graphene grid surfaces before and after the surface treatment (surface oxidation), the water drop was photographed, and the contact angle of the water was each measured by visual inspection of the photograph. As a result, the contact angle of water was 83° before the surface treatment, whereas the contact angle of water was 51° immediately after the surface treatment. In other words, the contact angle of water was reduced by the surface treatment. From this, it was verified that the hydrophilicity of the graphene grid surface was increased. The contact angle of water was measured again by the same method one hour after the surface treatment, and was 59° as shown in FIG. 6. That is, it was verified that the hydrophilicity of the graphene grid surface was maintained even one hour after the surface treatment.

### [Example 1]

In the present example, the graphene grid produced using the Mo grid (produced by Quantifoil Micro Tools GmbH, trade name: QUANTIFOIL) or the Au grid (produced by Quantifoil Micro Tools GmbH, trade name: QUANTIFOIL) was subjected to surface treatment (substituent introduction) to be reacted with a chlorine dioxide radical, and the graphene grid surface was modified (oxidized) to produce a graphene oxide (GO) with a modified (oxidized) surface onto which a substituent (hydroxyl group) is introduced. Further, according to the following scheme 1, functional group introduction was performed by introducing a new functional group onto a hydroxyl group on the oxidized graphene surface, to produce a graphene surface onto which a functional group is introduced (functional group-introduction).

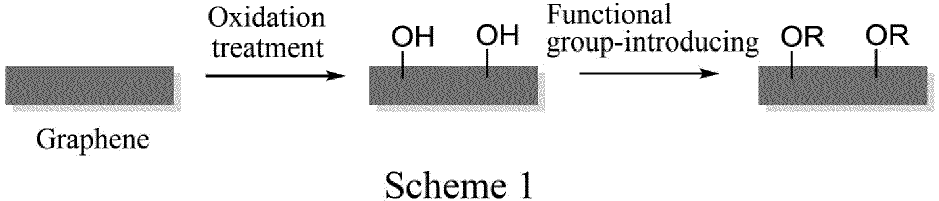

### [Surface Treatment (Substituent Introduction)]

First, the graphene grid produced using the Mo grid or the Au grid was reacted with a chlorine dioxide radical (surface treatment) in the same manner as in Reference Example 3. Each of the graphene grids before and after the surface treatment was evaluated by FT-IR measurement. As a result, whereas the graphene grid before the surface treatment (oxidation treatment of the graphene) was IR-inactive with no peak being observed, after the surface treatment, peaks derived from -OH (hydroxyl group) around 3000 cm⁻¹ were observed. In other words, oxidation of the graphene surface was verified by FT-IR measurement.

### [Functional Group Introduction]

A silane coupling agent was reacted to the graphene grid surface after the surface treatment to introduce a functional group (functional group introduction). Specifically, first, the graphene grid after the surface treatment was placed on a cover glass, and 25 mM of 3-glycidyloxypropyltrimethoxysilane (1) (120 µL, EtOH/H₂O=1/9) was placed on the graphene side, and was left to stand at 100°C for 5 minutes using a hot plate. Thereafter, an excessive silane coupling agent was washed away by washing with 100µL of an ethanol-water mixture solvent (EtOH/H₂O=1/9) for 3 times. Thereby, a graphene grid, which is the graphene grid onto which an epoxy group is introduced, was produced (the following scheme 2).

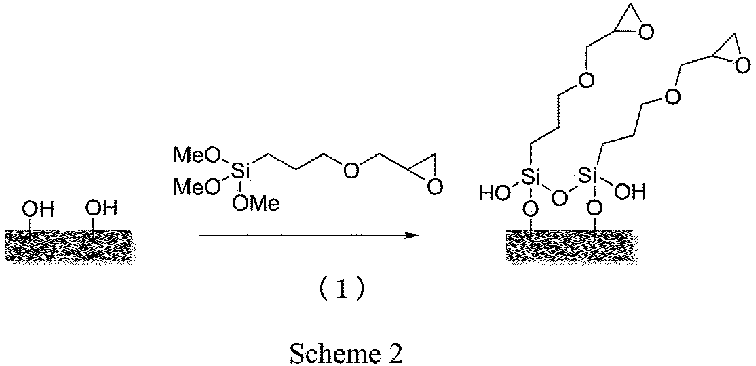

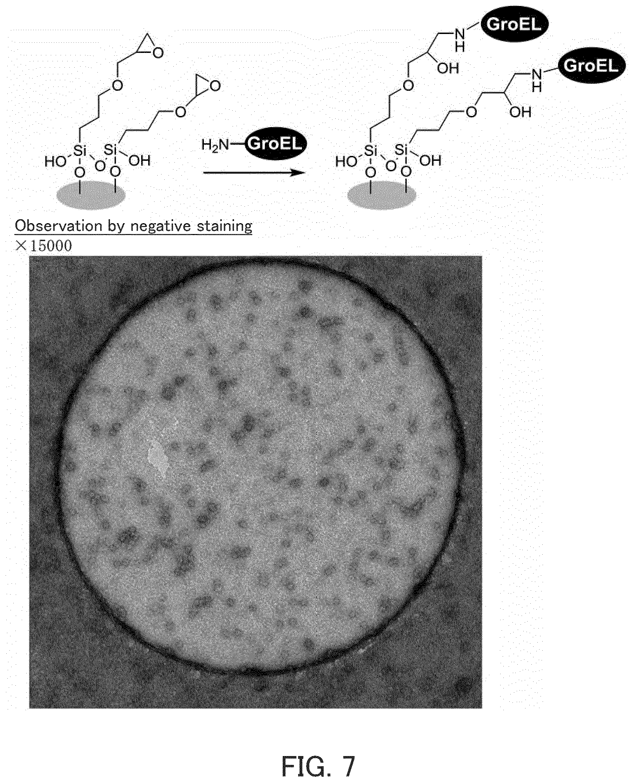

To the thus-produced graphene grid onto which the functional group (epoxy group) is introduced, a protein which is a structural analysis target substance to be analyzed by cryo-electron microscopy was joined (bonded). The scheme is as shown in the upper part of FIG. 7. Specifically, a HEPES buffer (25 mM HEPES pH8.0, 50 mM NaCl) containing 0.3 mg/mL of GroEL was placed on the graphene grid onto which the epoxy group is introduced, and was left to stand at room temperature for 5 minutes, thereby reacting the epoxy group introduced onto the graphene grid surface with an amino group in the GroEL to bond them together. Thereafter, excessive GroEL was washed away by washing with the HEPES buffer (5 µL) for 3 times.

The graphene grid surface to which the GroEL was bonded was observed at 15,000× magnification by a negative staining method using a 2% uranyl acetate aqueous solution. As shown in the photograph of the lower part of FIG. 7, it was observed that the GroEL was bonded to the graphene grid surface.

### [Example 2]

In the present example, a monolayered graphene (produced by ACS Material, trade name: CVCU1S22) on a copper substrate was subjected to surface treatment (substituent introduction) so as to react with a chlorine dioxide radical, and the graphene surface was modified (oxidized) to produce a graphene oxide (GO) with a modified (oxidized) surface onto which a substituent (hydroxyl group) is introduced. Further, according to the following scheme 3, functional group introduction was performed by introducing a new functional group onto a hydroxyl group in the oxidized graphene surface, thereby producing graphene onto which a functional group is introduced (functional group introduction). The graphene with the introduced functional group was evaluated by measurement of the contact angle of water, and Fourier transform infrared spectroscopy (FT-IR) measurement (produced by PerkinElmer Japan G.K., trade name: SPECTRUM TWO).

Then, a silane coupling agent was reacted with the graphene surface on the copper substrate after the surface treatment, to introduce a functional group (functional group introduction). Specifically, first, the graphene after the surface treatment was placed on a cover glass, 25 mM of 3-aminopropyltrimethoxysilane (2) (120 µL, EtOH/H₂O=1/9) was placed on the graphene side, and was heated at 100°C for 5 minutes using a hot plate. Thereafter, an excessive silane coupling agent was washed away by washing with 100 µL of an ethanol-water mixture solvent (EtOH/H₂O=1/9) for 3 times. Thereby, graphene on a copper substrate, which is the graphene on the copper substrate onto which a functional group containing an amino group is introduced, was produced (the following scheme 3).

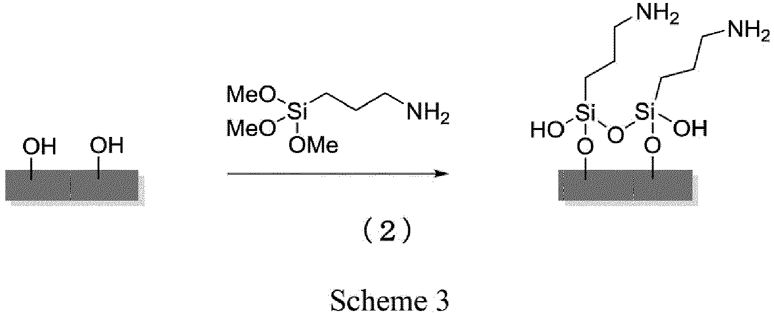

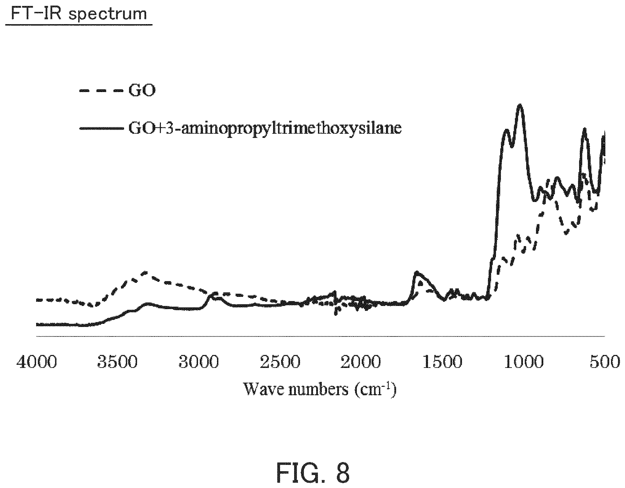

The graphene on the copper substrate onto which a functional group is introduced was evaluated by Fourier transform infrared spectroscopy (FT-IR) measurement (produced by PerkinElmer Japan G.K., trade name: SPECTRUM TWO). FIG. 8 shows the FT-IR spectrums. As shown in FIG. 8, in the spectrum after introducing a functional group, N-H stretching vibration derived from the primary amine group was observed at the wave numbers of 3325 cm⁻¹ and 3438 cm-¹. N-H vending vibration derived from the primary amine group was observed at the wave numbers of 1655 cm⁻¹. At each of the wave numbers of 1102 cm⁻¹ and 1019 cm⁻¹, Si-O-C stretching vibration and Si-O-Si stretching vibration were observed.

### [Example 3]

In the same manner as in Example 1, the graphene grid produced using the Mo grid (produced by Quantifoil Micro Tools GmbH, trade name: QUANTIFOIL) or the Au grid (produced by Quantifoil Micro Tools GmbH, trade name: QUANTIFOIL) was subjected to surface treatment (substituent introduction) to be reacted with a chlorine dioxide radical, and the graphene grid surface was modified (oxidized) to produce a graphene oxide (GO) with a modified (oxidized) surface onto which a substituent (hydroxyl group) is introduced.

A silane coupling agent was reacted with a graphene grid surface after the surface treatment to introduce a functional group (functional group introduction). Specifically, first, the graphene grid after the surface treatment was placed on a cover glass, and 25 mM of a silane compound containing a PEG group with a urethane bond (3)(120 µL, EtOH/H₂O=1/9) shown in the following scheme 4 was placed on the graphene side, and was left to stand at 100°C for 5 minutes using a hot plate. Thereafter, an excessive silane coupling agent was washed away by washing with 100 µL of an ethanol-water mixture solvent (EtOH/H₂O=1/9) for 3 times. As a result, a graphene grid, which is the graphene on the copper substrate onto which a PEG group (functional group) is introduced, was produced (the following scheme 5).

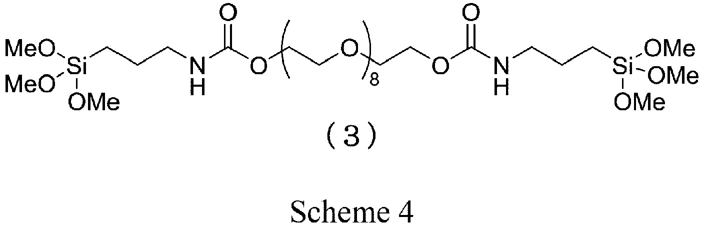

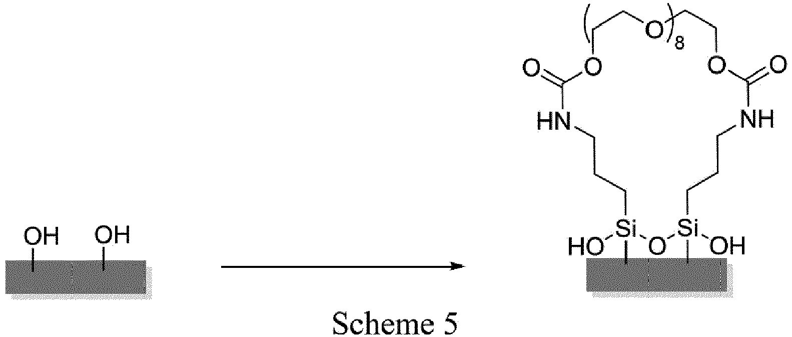

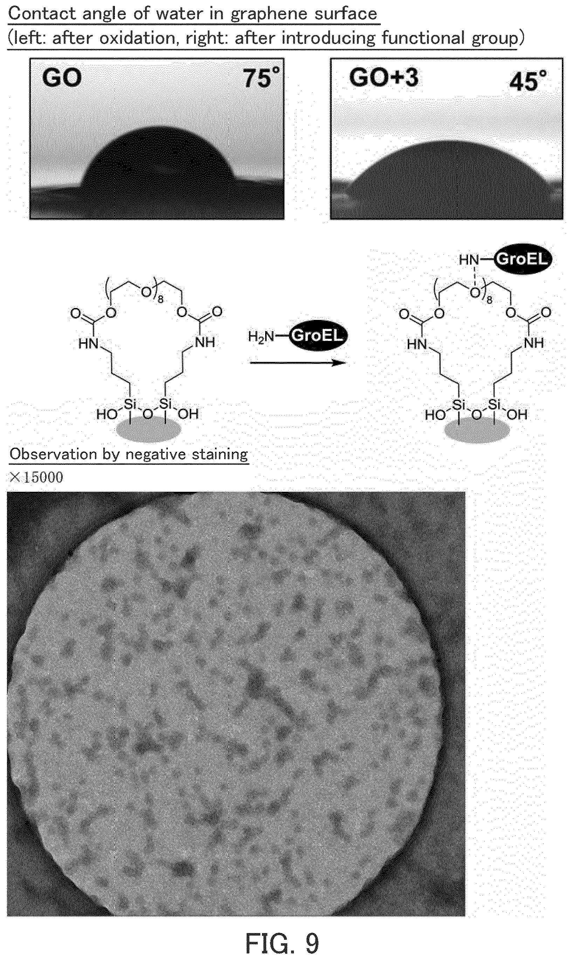

The contact angle of water in each of the graphene grid surfaces before and after the functional group introduction (surface modification after oxidation) was measured. The photographs in the upper part of FIG. 9 show the measurement results. As shown in FIG. 9, whereas the contact angle of water before introducing a functional group was 75°, the contact angle of water immediately after introducing a functional group was 45°. In other words, the contact angle of water was reduced by the functional group introduction. Thus, it was verified that hydrophilicity of the graphene (graphene grid) surface increased.

As shown in the scheme in the middle part of FIG. 9, to the graphene grid (left side in the scheme) onto which a PEG group (functional group) has been introduced through the functional group introduction, a protein (GroEL) which is a structural analysis target substance to be analyzed by cryo-electron microscopy was bonded to produce a grid for cryo-electron microscopy (right side in the scheme). Specifically, a HEPES buffer (25 mM HEPES pH8.0, 50 mM NaCl) containing 0.3 mg/mL of GroEL was placed on the graphene grid onto which a PEG group is introduced, and was left to stand at room temperature for 5 minutes, thereby reacting a PEG group introduced on the graphene grid surface with an amino group or a hydroxy group in the GroEL to bond them together by a hydrogen bond. Note that, in the scheme in the middle part of FIG. 3, the hydrogen bond between the PEG group and the GroEL is shown by a dotted line. However, the structure of the grid for cryo-electron microscopy shown in the scheme is merely an estimated example, and a structure of the grid for cryo-electron microscopy in the present example is not limited thereto.

The graphene grid (grid for cryo-electron microscopy) surface to which the GroEL was bonded was observed at 15,000× magnification by a negative staining method using a 2% uranyl acetate aqueous solution. The photograph in the lower part of FIG. 9 shows the result. As shown in FIG. 9, it was verified that the GroEL was bonded to the graphene grid surface.

### [Example 4]

In the same manner as in Example 1, the graphene grid produced using the Mo grid (produced by Quantifoil Micro Tools GmbH, trade name: QUANTIFOIL) or the Au grid (produced by Quantifoil Micro Tools GmbH, trade name: QUANTIFOIL) was subjected to surface treatment (substituent introduction) to be reacted with a chlorine dioxide radical, and the graphene grid surface was modified (oxidized) to produce a graphene oxide (GO) with a modified (oxidized) surface onto which a substituent (hydroxyl group) is introduced.

A silane coupling agent was reacted with a graphene grid surface after the surface treatment to introduce a functional group (functional group introduction). Specifically, first, the graphene grid after the surface treatment was placed on a cover glass, and 25 mM of silane containing a PEG group with a urea bond (4)(120 µL, EtOH/H₂O=1/9) shown in the following scheme 6 was placed on the graphene side, and was left to stand at 100°C for 5 minutes using a hot plate. Thereafter, an excessive silane coupling agent was washed away by washing with 100 µL of an ethanol-water mixture solvent (EtOH/H₂O=1/9) for 3 times. Thereby, a graphene grid, which is the graphene on the copper substrate onto which a PEG group (functional group) is introduced, was produced (the following scheme 7).

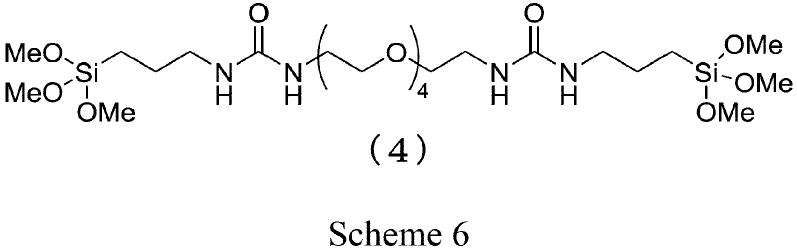

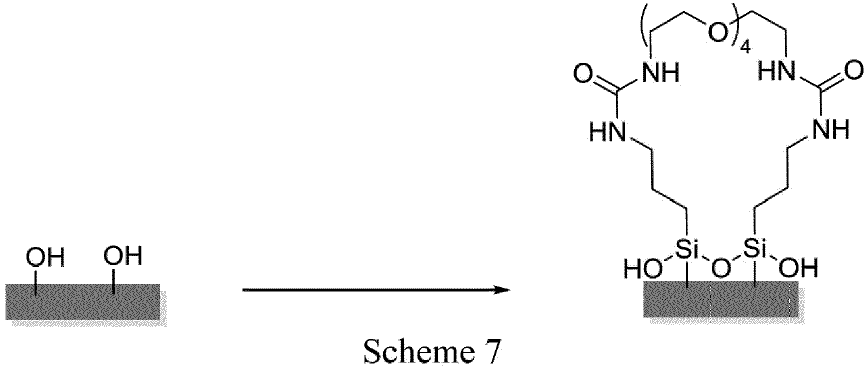

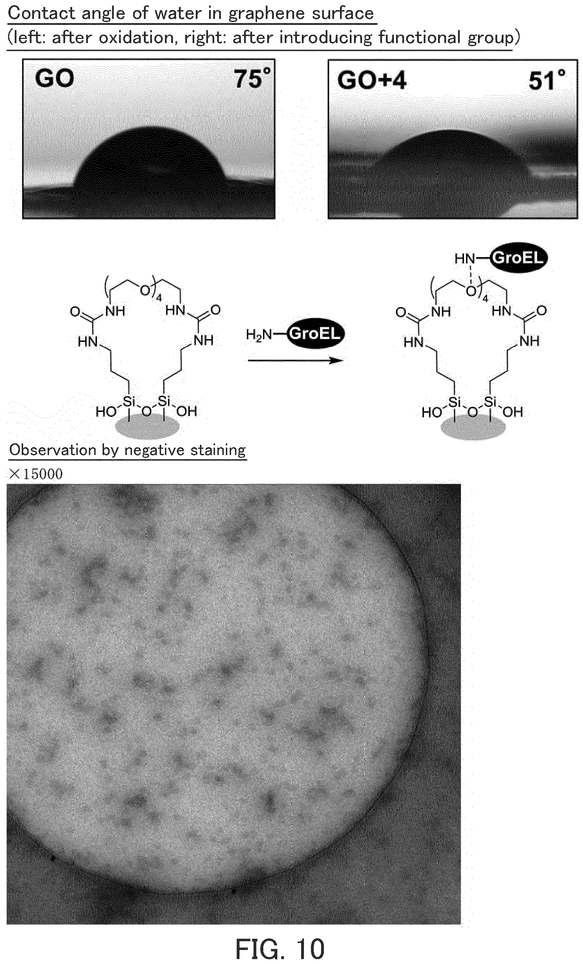

The contact angle of water in each of the graphene grid surfaces before and after the functional group introduction (surface modification after oxidation) was measured. The photographs in the upper part of FIG. 10 show the measurement results. As shown in FIG. 10, whereas the contact angle of water before introducing a functional group was 75°, the contact angle of water after introducing a functional group was 51°. In other words, the contact angle of water was reduced by the functional group introduction. Thus, it was verified that hydrophilicity of the graphene surface increased.

As shown in the scheme in the middle part of FIG. 10, to the graphene grid (left side in the scheme) onto which a PEG group (functional group) has been introduced through the functional group introduction, a protein (GroEL) which is a structural analysis target substance to be analyzed by cryo-electron microscopy was joined (bonded) to produce a grid for cryo-electron microscopy (right side in the scheme). Specifically, a HEPES buffer (25 mM HEPES pH8.0, 50 mM NaCl) containing 0.3 mg/mL of GroEL was placed on the graphene grid onto which a PEG group is introduced, and was left to stand at room temperature for 5 minutes, thereby reacting an epoxy group introduced in the graphene grid surface with an amino group or a hydroxy group in the GroEL to bond them together by a hydrogen bond. Note that, in the scheme in the middle part of FIG. 10, the hydrogen bond between the PEG group and the GroEL is shown by a dotted line. However, the structure of the grid for cryo-electron microscopy shown in the scheme is merely an estimated example, and a structure of the grid for cryo-electron microscopy in the present example is not limited thereto.

The graphene grid (grid for cryo-electron microscopy) surface to which the GroEL is bonded was observed at 15,000× magnification by a negative staining method using a 2% uranyl acetate aqueous solution. The photograph in the lower part of FIG. 10 shows the result. As shown in FIG. 10, it was verified that the GroEL was bonded to the graphene grid surface.

### [Example 5]

In the same manner as in Example 1, the graphene grid produced using the Mo grid (produced by Quantifoil Micro Tools GmbH, trade name: QUANTIFOIL) or the Au grid (produced by Quantifoil Micro Tools GmbH, trade name: QUANTIFOIL) was subjected to surface treatment (substituent introduction) to be reacted with a chlorine dioxide radical, and the graphene grid surface was modified (oxidized) to produce a graphene oxide (GO) with a modified (oxidized) surface onto which a substituent (hydroxyl group) is introduced.

A silane coupling agent was reacted with a graphene grid surface after the surface treatment to introduce a functional group (functional group introduction). Specifically, first, the graphene grid after the surface treatment was placed on a cover glass, and 25 mM of silane containing a maleimide group (5)(120 µL, EtOH/H₂O=1/9) shown in the following scheme 8 was placed on the graphene side, and was left to stand at 100°C for 5 minutes using a hot plate. Thereafter, an excessive silane coupling agent was washed away by washing with 100 µL of an ethanol-water mixture solvent (EtOH/H₂O=1/9) for 3 times. As a result, a graphene grid, which is the graphene on the copper substrate onto which a maleimide group (functional group) is introduced, was produced (the following scheme 9).

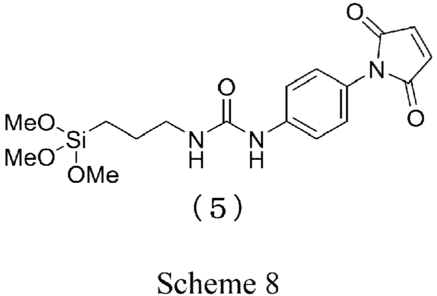

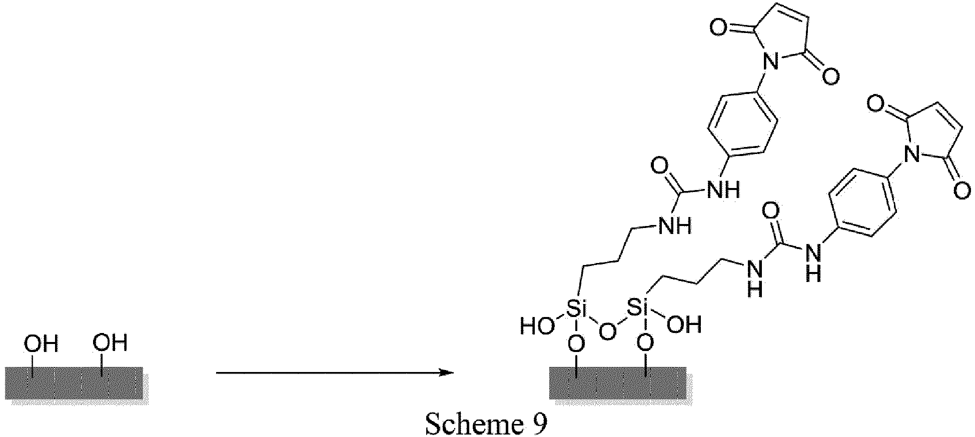

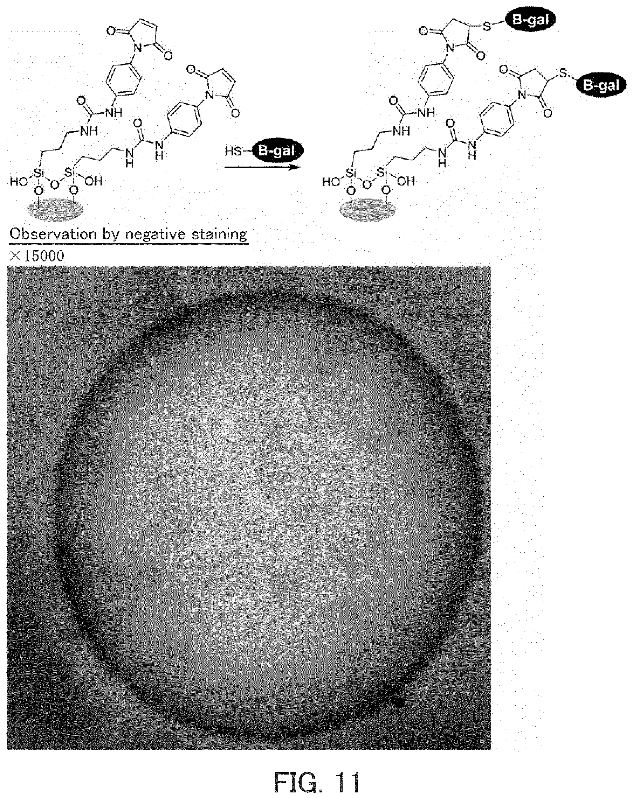

As shown in the scheme in the upper part of FIG. 11, to the graphene grid (left side in the scheme) onto which a maleimide group (functional group) has been introduced through the functional group introduction, a protein (β-galactosidase) which is a structural analysis target substance to be analyzed by cryo-electron microscopy is joined (bonded), to produce a grid for cryo-electron microscopy (right side in the scheme). Specifically, a Tris buffer (25 mM Tris pH7.0, 50 mM NaCl, 2 mM MgCl₂, 1 mM DTT) containing 0.5 mg/mL of β-galactosidase (B-gal) is placed on the graphene grid onto which a maleimide group is introduced, and was left to stand at room temperature for 5 minutes, thereby reacting the maleimide group introduced onto the graphene grid surface with a sulfhydryl group in the β-galactosidase (B-gal) to bond them together. Thereafter, excessive β-galactosidase (B-gal) was washed away by washing with the Tris buffer (5 µL) for 3 times.

The graphene grid (grid for cryo-electron microscopy) surface to which β-galactosidase was bonded was observed at 15,000× magnification by a negative staining method using a 2% uranyl acetate aqueous solution. The photograph in the lower part of FIG. 11 shows the result. As shown in FIG. 11, it was verified that the β-galactosidase was bonded to the graphene grid surface.

### [Example 6]

In the same manner as in Example 2, a monolayered graphene (produced by ACS Material, trade name: CVCU1S22) on a copper substrate was subjected to surface treatment (substituent introduction) to be reacted with a chlorine dioxide radical, and the graphene surface was modified (oxidized) to produce a graphene oxide (GO) with a modified (oxidized) surface onto which a substituent (hydroxyl group) is introduced.

Then, a silane coupling agent was reacted with a graphene surface on the copper substrate after the surface treatment, to introduce a functional group (functional group introduction). Specifically, first, the graphene after the surface treatment was placed on a cover glass, 25 mM of silane containing a carboxylic acid group with a urea bond (6)(120 µL, EtOH/H₂O=1/9) shown in the following scheme 10 was placed on the graphene side, and was left to stand at 100°C for 5 minutes using a hot plate. Thereafter, an excessive silane coupling agent was washed away by washing with 100 µL of an ethanol-water mixture solvent (EtOH/H₂O=1/9) for 3 times. As a result, graphene, which is the graphene on the copper substrate onto which a carboxylic acid group is introduced, was produced (the following scheme 11).

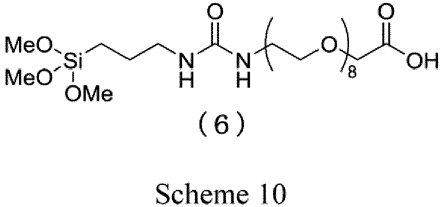

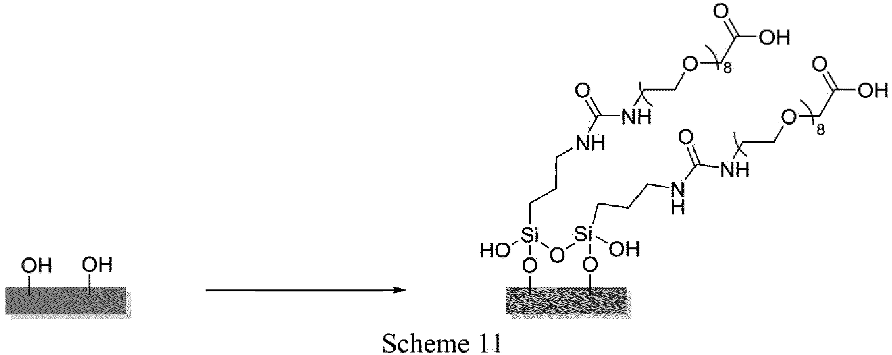

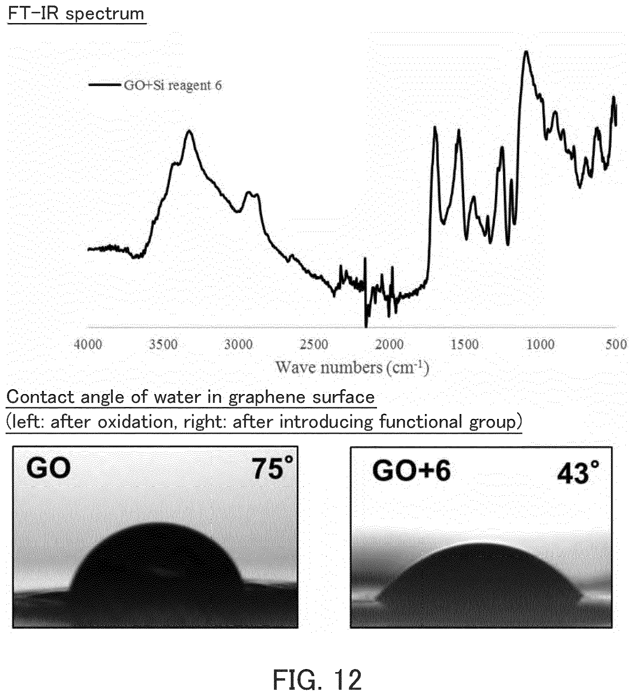

The graphene on the copper substrate onto which a functional group is introduced was evaluated by Fourier transform infrared spectroscopy (FT-IR) measurement. The upper part of FIG. 12 shows the FT-IR spectrum. As shown in FIG. 12, in the spectrum after introducing a functional group, C=O stretching vibration derived from a urea bond and a terminal carboxylic acid carbonyl group was observed at the wave numbers of 1701 cm⁻¹. N-H stretching vibration derived from an amido group of a urea bond was observed at the wave numbers of 3327 cm⁻¹, and N-H bending vibration thereof was observed at the wave numbers of 1559 cm⁻¹. Si-O-C stretching vibration and Si-O-Si stretching vibration were observed at each of the wave numbers of 1100 cm⁻¹ and 1007 cm⁻¹.

The contact angle of water in each of the graphene surfaces on the copper substrates before and after the functional group introduction (surface modification after oxidation) was measured. The photographs in the lower part of FIG. 12 show the measurement results. As shown in FIG. 12, whereas the contact angle of water before introducing a functional group was 75°, the contact angle of water after introducing a functional group was 43°. In other words, the contact angle of water was reduced by the functional group introduction. Thus, it was verified that hydrophilicity of the graphene surface increased.

### [Example 7]

In the same manner as in Example 2, a monolayered graphene (produced by ACS Material, trade name: CVCU1S22) on a copper substrate was subjected to surface treatment (substituent introduction) to be reacted with a chlorine dioxide radical, and the graphene surface was modified (oxidized) to produce a graphene oxide (GO) with a modified (oxidized) surface onto which a substituent (hydroxyl group) is introduced.

A silane coupling agent is reacted with the graphene surface on the copper substrate after the surface treatment to introduce a functional group (functional group introduction).

Specifically, first, the graphene after the surface treatment was placed on a cover glass, and 25 mM of silane containing an NHS ester group (7)(120 µL, EtOH/H₂O=1/9) shown in the following scheme 12 was placed on the graphene side, and was left to stand at 100°C for 5 minutes using a hot plate. Thereafter, an excessive silane coupling agent was washed away by washing with 100 µL of an ethanol-water mixture solvent (EtOH/H₂O=1/9) for 3 times. As a result, graphene on a copper substrate, which is the graphene on the copper substrate onto which an NHS ester group (functional group) is introduced, was produced (scheme 13).

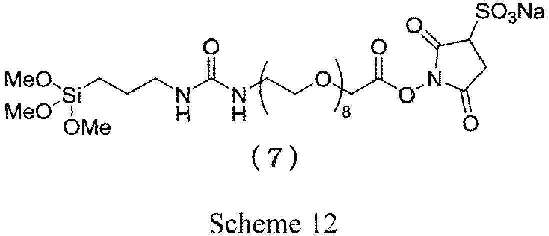

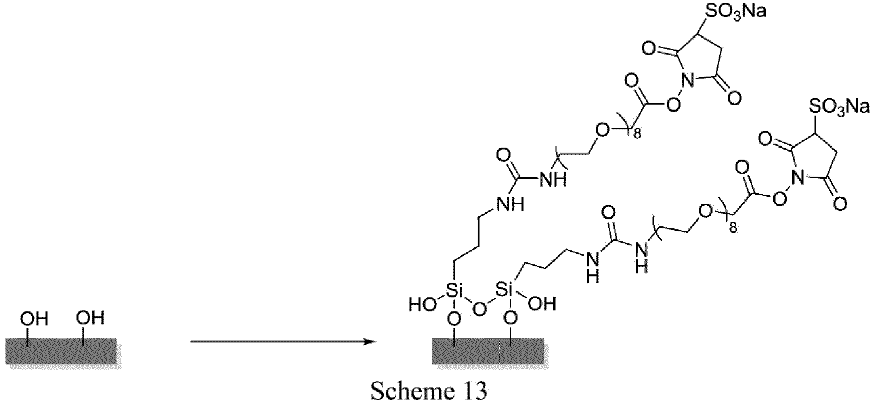

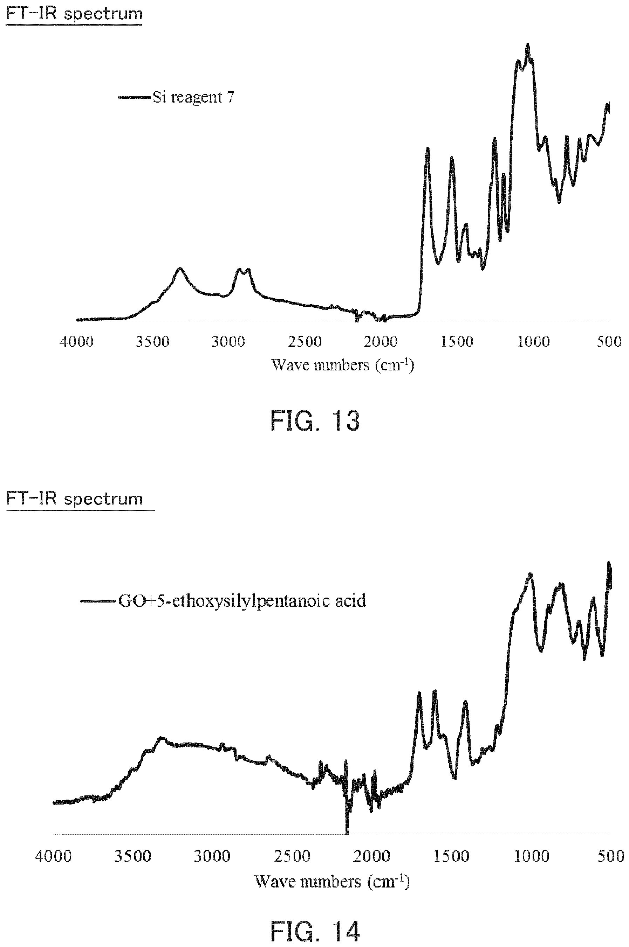

The graphene on the copper substrate onto which a functional group is introduced was evaluated by Fourier transform infrared spectroscopy (FT-IR) measurement. FIG. 13 shows the FT-IR spectrum. As shown in FIG. 13, in the spectrum after introducing a functional group, C=O stretching vibration derived from a carbonyl group of a urea bond was observed at the wave numbers of 1692 cm⁻¹. N-H stretching vibration derived from an amido group of a urea bond was observed at the wave numbers of 3317 cm⁻¹, and N-H bending vibration thereof was observed at the wave numbers of 1530 cm⁻¹. C-SO₃⁻ stretching vibration derived from a sulfonic group was observed at each of the wave numbers of 1194 cm⁻¹ and 1037 cm⁻¹. Si-O-C stretching vibration and Si-O-Si stretching vibration were observed at each of the wave numbers of 1098 cm⁻¹ and 1007 cm⁻¹.

### [Example 8]

In the same manner as in Example 2, a monolayered graphene (produced by ACS Material, trade name: CVCU1S22) on a copper substrate was subjected to surface treatment (substituent introduction) to be reacted with a chlorine dioxide radical, and the graphene surface was modified (oxidized) to produce a graphene oxide (GO) with a modified (oxidized) surface onto which a substituent (hydroxyl group) is introduced.

A silane coupling agent is reacted with the graphene surface on the copper substrate after the surface treatment to introduce a functional group (functional group introduction). Specifically, first, the graphene after the surface treatment was placed on a cover glass, and 25 mM of 5-triethoxysilyl pentanoic acid (8)(120 µL, EtOH/H₂O=1/9) was placed on the graphene side, and was left to stand at 100°C for 5 minutes using a hot plate. Thereafter, an excessive silane coupling agent was washed away by washing with 100 µL of an ethanol-water mixture solvent (EtOH/H₂O=1/9) for 3 times. As a result, graphene on a copper substrate, which is the graphene on the copper substrate onto which a carboxylic acid group has been introduced, was produced (scheme 14).

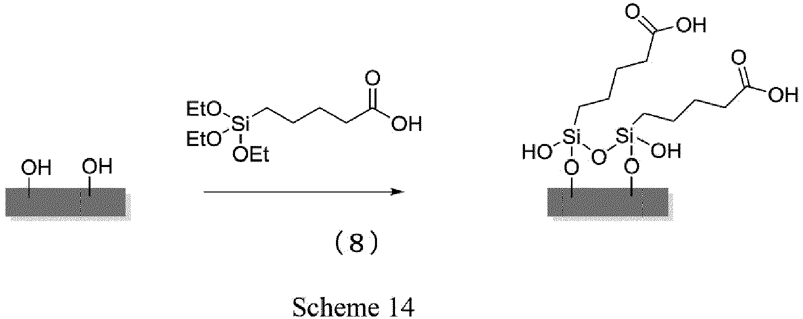

The graphene on the copper substrate onto which a functional group is introduced was evaluated by Fourier transform infrared spectroscopy (FT-IR) measurement. FIG. 14 shows the FT-IR spectrum. As shown in FIG. 14, in the spectrum after introducing a functional group, C=O stretching vibration derived from a carbonyl group was observed at the wave numbers of 1702 cm⁻¹. Si-O-C stretching vibration and Si-O-Si stretching vibration were observed at each of the wave numbers of 1100 cm⁻¹ and 1004 cm⁻¹.

### [Example 9]

In the same manner as in Example 2, a monolayered graphene (produced by ACS Material, trade name: CVCU1S22) on a copper substrate was subjected to surface treatment (substituent introduction) to be reacted with a chlorine dioxide radical, and the graphene surface was modified (oxidized) to produce a graphene oxide (GO) with a modified (oxidized) surface onto which a substituent (hydroxyl group) is introduced.

Then, a silane coupling agent was reacted with the graphene surface on the copper substrate after the surface treatment, to introduce a functional group (functional group introduction). Specifically, first, the graphene after the surface treatment was placed on a cover glass, 25 mM of a silane aqueous solution containing a sulfonic acid group (9)(120 µL) was placed on the graphene side, and was left to stand at 100°C for 5 minutes using a hot plate. Thereafter, an excessive silane coupling agent was washed away by washing with distilled water (100 µL) for 3 times. As a result, graphene on a copper substrate, which is the graphene on the copper substrate onto which a sulfonic acid group is introduced, was produced (the following scheme 15).

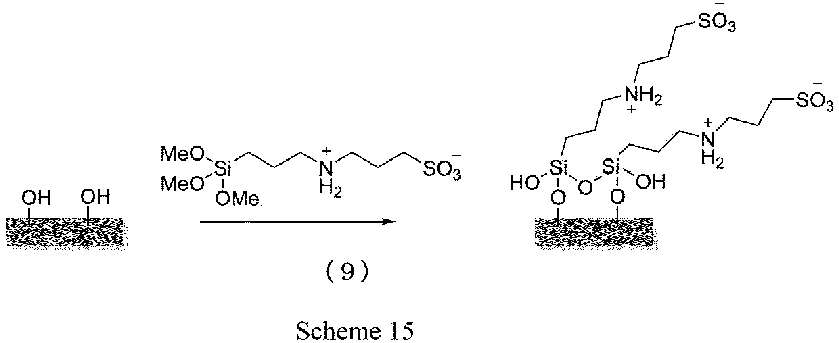

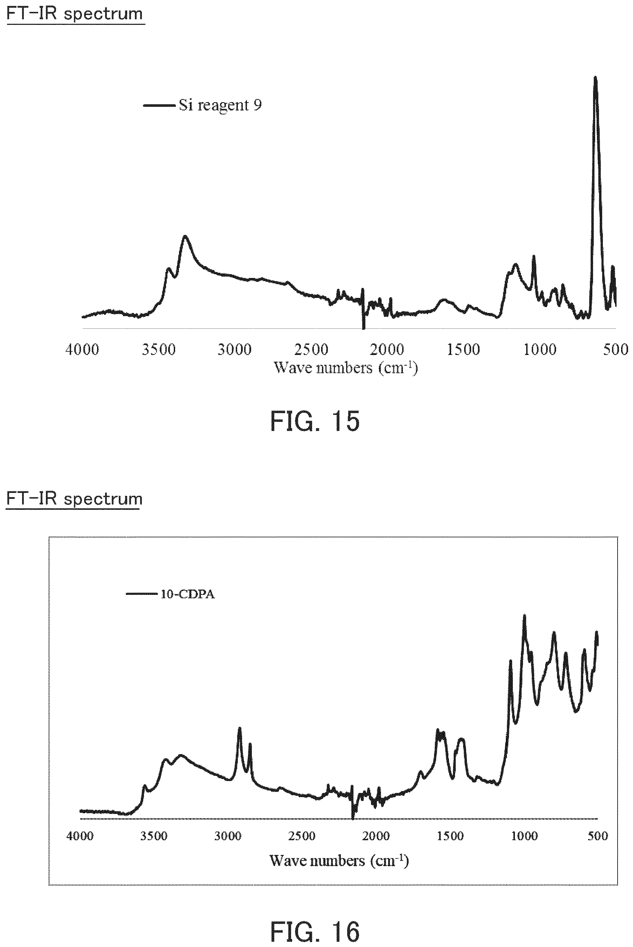

The graphene on the copper substrate onto which a functional group is introduced was evaluated by Fourier transform infrared spectroscopy (FT-IR) measurement. FIG. 15 shows the FT-IR spectrum. As shown in FIG. 15, in the spectrum after introducing a functional group, NH₂⁺ bending vibration derived from an ammonium cation was observed at the wave numbers of 1474 cm⁻¹, and NH₂⁺ stretching vibration derived thereof was observed at the wave numbers of 3323 cm⁻¹. C-SO₃⁻ stretching vibration derived from a sulfonic group was observed at each of the wave numbers of 1204 cm⁻¹ and 1040 cm⁻¹. Si-O-C stretching vibration and Si-O-Si stretching vibration were observed at each of the wave numbers of 1158 cm⁻¹ and 1005 cm⁻¹.

### [Example 11]

In the same manner as in Example 2, a monolayered graphene (produced by ACS Material, trade name: CVCU1S22) on a copper substrate was subjected to surface treatment (substituent introduction) to be reacted with a chlorine dioxide radical, and the graphene surface is modified (oxidized) to produce a graphene oxide (GO) with a modified (oxidized) surface onto which a substituent (hydroxyl group) is introduced.

Then, a phosphonic acid derivative was reacted with the graphene surface on the copper substrate after the surface treatment, to introduce a functional group (functional group introduction). Specifically, first, the graphene after the surface treatment was placed on a cover glass, 25 mM of a phosphonic acid solution containing a carboxylic acid group (produced by DOJINDO LABORATORIES, trade name: 10-CDPA) (10)(120 µL) was placed on the graphene side, and was left to stand at 80°C for 5 minutes using a hot plate. Thereafter, an excessive phosphonic acid derivative was washed away by washing with ethanol (100 µL) for 3 times. As a result, graphene on a copper substrate, which is the graphene on the copper substrate onto which a carboxylic acid group is introduced, was produced (the following scheme 16).

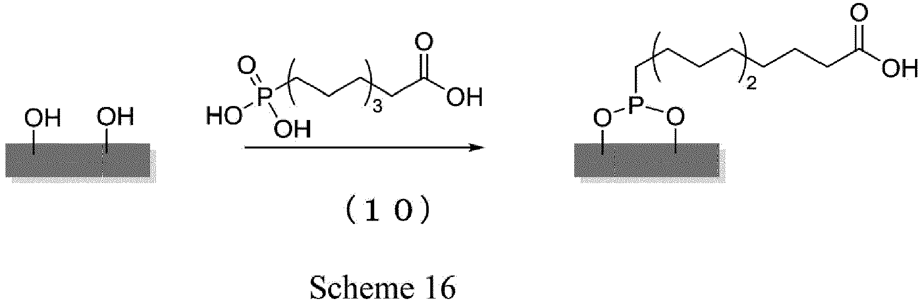

The graphene on the copper substrate onto which a functional group is introduced was evaluated by Fourier transform infrared spectroscopy (FT-IR) measurement. FIG. 16 shows the FT-IR spectrum. As shown in FIG. 16, in the spectrum after introducing a functional group, C=O stretching vibration derived from a carbonyl group was observed at the wave numbers of 1700 cm⁻¹. P-O stretching vibration and P=O stretching vibration were observed at each of the wave numbers of 1093 cm⁻¹ and 1007 cm⁻¹.

### [Example 12]

The graphene grid (grid for cryo-electron microscopy) to which a structural analysis target substance to be analyzed by cryo-electron microscopy is bonded in each of the examples was actually subjected to structural analysis with cryo-electron microscopy. As a result, the structural analysis could be performed with extremely high accuracy and high resolution.

### [Example 13]

In the same manner as in Example 2, a monolayered graphene (produced by ACS Material, trade name: CVCU1S22) on a copper substrate was subjected to surface treatment (substituent introduction) to be reacted with a chlorine dioxide radical, and the graphene surface was modified (oxidized) to produce a graphene oxide (GO) with a modified (oxidized) surface onto which a substituent (hydroxyl group) is introduced.

Then, a phosphonic acid derivative was reacted with the graphene surface on the copper substrate after the surface treatment, to introduce a functional group (functional group introduction). Specifically, first, the graphene after the surface treatment was placed on a cover glass, 25 mM of a phosphonic acid solution containing a carboxylic acid group (produced by DOJINDO LABORATORIES, trade name: FHPA) (11)(120 µL) was placed on the graphene side, and was left to stand at 80°C for 5 minutes using a hot plate. Thereafter, an excessive phosphonic acid derivative was washed away by washing with ethanol (100 µL) for 3 times. Thereby, fluorine was introduced onto the graphene on the copper substrate (the following scheme 17).

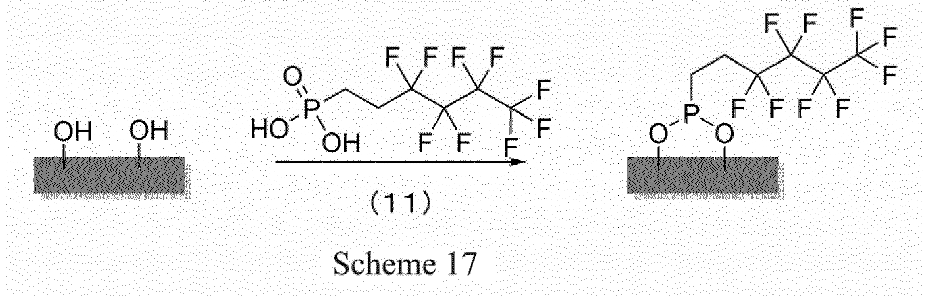

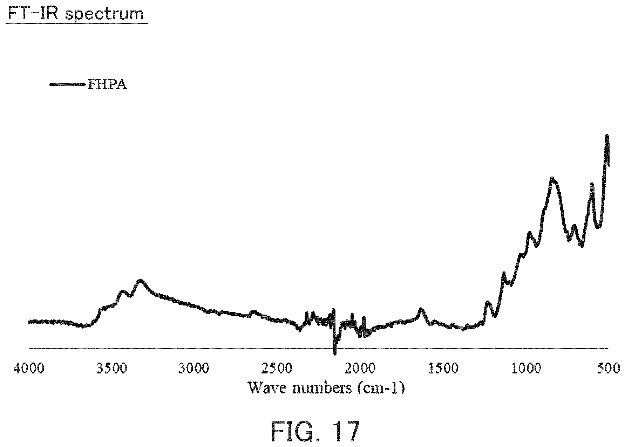

The oxidized graphene on the copper substrate onto which a functional group is introduced was evaluated by Fourier transform infrared spectroscopy (FT-IR) measurement. FIG. 17 shows the FT-IR spectrum. As shown in FIG. 17, in the spectrum after introducing a functional group, C-F stretching vibration derived from fluorine was observed at the wave numbers of 1235 cm⁻¹. P-O stretching vibration and P=O stretching vibration were observed at each of the wave numbers of 1112 cm⁻¹ and 984 cm⁻¹.

### [Example 13]

In the same manner as in Example 1, the graphene grid produced using the Mo grid (produced by Quantifoil Micro Tools GmbH, trade name: QUANTIFOIL) or the Au grid (produced by Quantifoil Micro Tools GmbH, trade name: QUANTIFOIL) was subjected to surface treatment (substituent introduction) to be reacted with a chlorine dioxide radical, and the graphene grid surface was modified (oxidized) to produce a graphene oxide (GO) with a modified (oxidized) surface onto which a substituent (hydroxyl group) is introduced.

A silane coupling agent was reacted with the graphene grid surface after the surface treatment to introduce a functional group (functional group introduction). Specifically, first, the graphene grid after the surface treatment was placed on a cover glass, and 10 mg/mL of a zwitterion-type silane coupling agent (12)(5 µL, EtOH/H₂O=1/9) shown in the following scheme 18 was placed on the graphene side, and was left to stand at 100°C for 30 minutes using a hot plate. Thereafter, an excessive silane coupling agent was washed away by washing with 10 µL of an ethanol-water mixture solvent (EtOH/H₂O=1/9) for 3 times. As a result, a graphene grid, which is the graphene grid onto which zwitterion (functional group) is introduced, was produced (the following scheme 19).

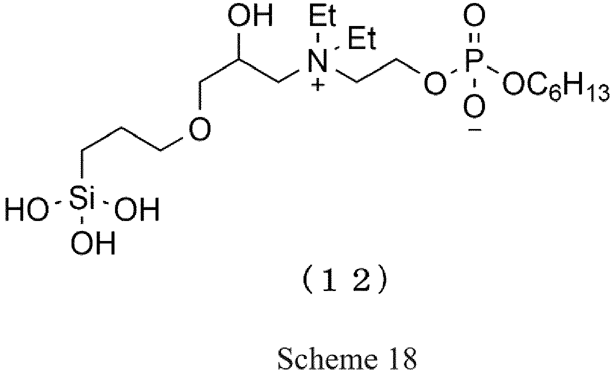

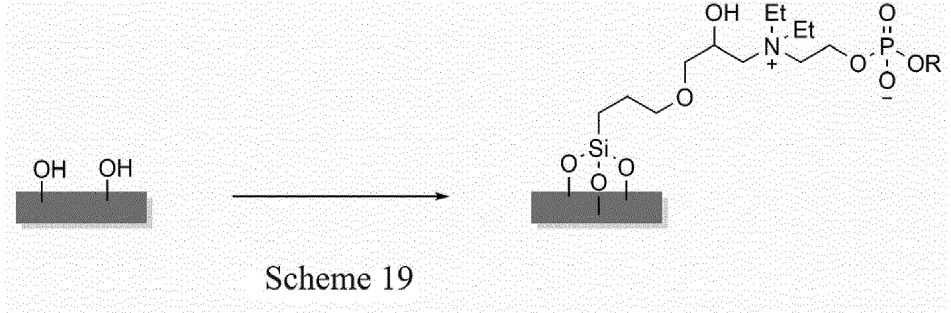

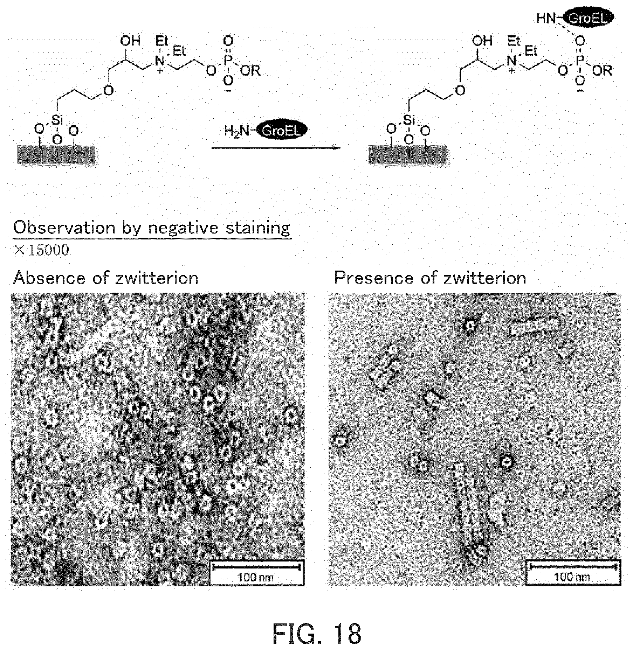

As shown in the scheme in the upper part of FIG. 18, to the graphene grid (left side in the scheme) onto which zwitterion (functional group) is introduced through the functional group introduction, a protein (GroEL) which is a structural analysis target substance to be analyzed by cryo-electron microscopy was joined (bonded), to produce a grid for cryo-electron microcopy (right side in the scheme). Specifically, an aqueous solution containing 0.3 mg/mL of GroEL was placed on the graphene grid onto which zwitterion is introduced, and was left to stand at room temperature for 5 minutes, thereby interacting zwitterion introduced in the graphene grid surface and the GroEL, and bonding them together. Thereafter, excessive GroEL was washed away by washing with water (5 µL) for 3 times.

The graphene grid (grid for cryo-electron microscopy) surface to which the GroEL was bonded was observed at 15,000× magnification by a negative staining method using a 2% uranyl acetate aqueous solution. The photograph in the lower part of FIG. 18 shows the result. The GroEL on a grid with no zwitterion introduced is shown in the left lower part of FIG. 18 as a comparison. As shown in FIG. 18, it was verified that the GroEL was bonded to the graphene grid surface, and orientation of the GroEL is changed by introducing zwitterion.

As demonstrated by the Examples, according to the present invention, a measurement sample for cryo-electron microscopy can be easily prepared in a very short time. Furthermore, as demonstrated by the Examples, the structural analysis of various proteins such as β-galactosidase, GroEL, and V1-ATPase can be performed with extremely high accuracy and high resolution without tagging.

While the present invention has been described above with reference to illustrative embodiments, the present invention is by no means limited thereto. Various changes and variations that may become apparent to those skilled in the art may be made in the configuration and specifics of the present invention without departing from the scope of the present invention.

### Industrial Applicability

As described above, according to the present invention, it is possible to provide a grid for cryo-electron microscopy, a method for producing a grid for cryo-electron microscopy, and a method for analyzing a structural analysis target substance, which can reduce or prevent uneven distribution, uneven orientation, and the like of a structural analysis target substance, in a structural analysis by cryo-electron microscopy. According to the present invention, for example, a grid for cryo-electron microscopy in which a structural analysis target substance such as a protein is bonded can be produced in a very short time, and the structural analysis of the structural analysis target substance can be performed with extremely high resolution, so that its industrial use value is great.

This application claims priority from Japanese Patent Application No. 2021-165333 filed on October 7, 2021. The entire subject matter of the Japanese Patent Application is incorporated herein by reference.

### Reference Signs List

- 1:: petri dish
- 2:: lid
- 3:: petri dish
- 4:: petri dish
- 5:: radical generation reaction system
- 6:: graphene
- 11:: organic layer (organic phase)
- 12:: aqueous layer (aqueous phase)

## Claims

1. A graphene grid comprising a graphene surface onto which a functional group comprising at least one atom selected from the group consisting of a silicon atom and a phosphorus atom is introduced.

2. The graphene grid according to claim 1, wherein a substituent is introduced onto the graphene surface, and the functional group is introduced by a reaction of the substituent.

3. The graphene grid according to claim 2, wherein
the substituent is a substituent comprising at least one group selected from the group consisting of a hydroxyl group, a carboxy group, an aldehyde group, a substituent containing a ketone group or a carbonyl group, a substituent containing an ether bond, and a substituent containing an ester bond.

4. The graphene grid according to claim 2 or 3, wherein the functional group is introduced onto the graphene surface by a reaction of the substituent with at least one material selected from the group consisting of a silane coupling agent and a phosphonic acid derivative.

5. The graphene grid according to any one of claims 1 to 4, wherein
the functional group comprising at least one atom selected from the group consisting of a silicon atom and a phosphorus atom is a functional group having at least one structure selected from the group consisting of a hydroxy group, a carboxy group, an aldehyde group, a carbonyl group, an ether bond, an epoxy group, an ester bond, an amino group, an imino group, a maleimide group, a sulfonyl group, a sulfonyloxy group, a fluoroalkyl group, a cyano group, an isocyanate group, a vinyl group, a styryl group, a methacrylic group, an acrylic group, a ureido group, a mercapto group, an isothiocyanate group, an azido group, an ethynyl group, an imidoester group, a halide, an activated carboxy group, an NHS ester group, an acid chloride, acid anhydride, and a fluoro ester.

6. A grid for cryo-electron microscopy, comprising the graphene grid according to any one of claims 1 to 5 to which a target substance for a structural analysis by the cryo-electron microscopy is bonded.

7. A method for producing a graphene grid comprising a graphene surface onto which a functional group comprising at least one atom selected from the group consisting of a silicon atom and a phosphorus atom is introduced, the method comprising:
introducing the functional group comprising the silicon atom by a reaction of a substituent on the graphene surface with at least one material selected from the group consisting of a silane coupling agent and a phosphonic acid derivative.

8. The method according to claim 7, comprising:
introducing the substituent by reacting a graphene surface with a halogen oxide radical so that the graphene surface is modified.

9. The method according to claim 8, wherein
the halogen oxide radical is a chlorine dioxide radical.

10. The method according to any one of claims 7 to 9, wherein
the substituent is at least one substituent selected from the group consisting of a hydroxyl group, a carboxy group, an aldehyde group, a substituent comprising at least one substituent selected from the group consisting of a ketone group and a carbonyl group, a substituent comprising an ether bond, and a substituent comprising an ester bond.

11. The method according to any one of claims 7 to 10, wherein
the functional group comprising at least one atom selected from the group consisting of the silicon atom or the phosphorus atom is a functional group comprising at least one substituent selected from the group consisting of a hydroxy group, a carboxy group, an aldehyde group, a carbonyl group, an ether bond, an epoxy group, an ester bond, an amino group, an imino group, a maleimide group, a sulfonyl group, a sulfonyloxy group, a fluoroalkyl group, a cyano group, an isocyanate group, a vinyl group, a styryl group, a methacrylic group, an acrylic group, a ureido group, a mercapto group, an isothiocyanate group, an azido group, an ethynyl group, an imidoester group, a halide, an activated carboxy group, an NHS ester group, an acid chloride, acid anhydride, and a fluoro ester.

12. A method for producing a grid for cryo-electron microscopy, comprising:
binding a target substance for a structural analysis by the cryo-electron microscopy to the graphene grid produced by the method according to any one of claims 7 to 11.

13. A method for analyzing a structural analysis target substance using cryo-electron microscopy, comprising:
preparing a grid for structural analysis; and
analyzing a structure of a target material for the structural analysis, wherein
in the preparing a grid for structural analysis, the structural analysis target substance is bonded to the graphene grid according to any one of claims 1 to 5 or the graphene grid produced by the method according to any one of claims 7 to 11, or the grid for cryo-electron microscopy according to claim 6 or the grid for cryo-electron microscopy produced by the method according to claim 12 is prepared, and
in the analyzing the structure of the target substance, the target substance bonded to the graphene grid is analyzed by the cryo-electron microscopy.

14. The method according to claim 13, wherein
the target substance for the structural analysis is an organic substance.

15. The method according to claim 14, wherein
the organic substance is a protein.
